(19) Europäisches Patentamt
European Patent Office
Office européen des brevets

(11) Publication number : 0 517 542 B1

(12) # EUROPEAN PATENT SPECIFICATION

(45) Date of publication of patent specification : **30.08.95 Bulletin 95/35**

(51) Int. Cl.$^6$ : **H05B 33/14,** H05B 33/28

(21) Application number : **92305184.1**

(22) Date of filing : **05.06.92**

(54) **Organic electroluminescence devices.**

(30) Priority : **05.06.91 JP 133928/91**
**17.03.92 JP 60148/92**

(43) Date of publication of application :
**09.12.92 Bulletin 92/50**

(45) Publication of the grant of the patent :
**30.08.95 Bulletin 95/35**

(84) Designated Contracting States :
**DE FR GB NL**

(56) References cited :
**EP-A- 0 399 508**
**US-A- 4 539 507**
**US-A- 4 720 432**
**US-A- 4 769 292**
**PATENT ABSTRACTS OF JAPAN, unexamined applications, C field, vol. 15, no. 353,september 06,1991**
**PATENT ABSTRACTS OF JAPAN, unexamined applications, C field, vol. 15, no. 302,August 02, 1991 THE PATENT OFFICE JAPANESE GOVERNMENT page 50 C 855**

(73) Proprietor : **SUMITOMO CHEMICAL COMPANY, LIMITED**
**5-33, Kitahama 4-chome**
**Chuo-ku**
**Osaka (JP)**
Proprietor : **Yasuhiko, Shirota**
**3-5-7 Daikoku-cho**
**Toyonaka-shi (JP)**

(72) Inventor : **Noguchi, Takanobu**
**12, Ninomiya-1-chome**
**Tsukuba-shi (JP)**
Inventor : **Nakamo, Tsuyoshi**
**40-1, Kasuga-2-chome**
**Tsukuba-shi (JP)**
Inventor : **Ohnishi, Toshihiro**
**7, Kasuga-3-chome**
**Tsukuba-shi (JP)**
Inventor : **Kuwabara, Masato**
**40-1 Kasuga-2-chome**
**Tsukuba-shi (JP)**

(74) Representative : **Cresswell, Thomas Anthony**
**J.A. Kemp & Co.**
**14 South Square**
**Gray's Inn**
**London WC1R 5LX (GB)**

**EP 0 517 542 B1**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### BACKGROUND OF THE INVENTION

#### Field of the Invention

The present invention relates to an organic electroluminescence device (hereinafter referred to as organic EL device), and more particularly to an organic EL device with a particular aromatic amine compound as hole transport material.

#### Description of Related Art

Hitherto, inorganic electroluminescence devices are used, for example, in flat light sources as back light, display devices (e.g. flat panel display) and the like. However, AC source of high-voltage is necessary for emission of light from the devices.

Recently, C.W. Tang et al. produced an organic EL device of two-layer structure composed of a luminous layer comprising an organic fluorescent dye and a hole transport layer, laid on the former layer, comprising a triphenyldiamine derivative to realize an organic EL device driven by DC source of low-voltage and having high efficiency and high luminance (US Patent No. 4,539,507). The organic EL device, as compared with inorganic ones, has characteristics that it can be driven by low voltage, has high luminance and in addition that a number of lights different in color can easily be obtained. Because of this, many trials are reported on device structures, organic fluorescent dyes and organic charge transport compounds [Japanese Journal of Applied Physics, Vol. 27, L269 (1988); Journal of Applied Physics, Vol. 65, p, 3610 (1989)].

Shirota et al. describe the synthesis and properties of aromatic amine compounds having star-shaped molecular structures [Chemistry Letters, page 1145 (1989); and Preprint of the 61st Annual Convention in Spring of the Japanese Chemical Society, 3D337 and 3D338 (1992)]. It was reported that these aromatic amine compounds had high glass transition temperatures and worked as p-type semiconductors. Also, it was reported that they were expected to find uses as charge transport materials such as organic electroluminescence materials. See, Advanced Materials 3 (11), 549 (1991); and Chemistry Letters, (10), 1731 (1991).

Organic EL devices so far reported are of high luminance, but have a problem that the life of the luminous device is short. The reason for this is said to be a change in the structure of the organic layer by generation of Joule's heat and deterioration of the layer caused by the change. Because of this, charge transport materials constituting a thermally stable organic layer have been demanded.

The present inventors have extensively studied to improve the heat resistance of the organic EL devices, and as a result have found that by using as the hole transport material particular aromatic amine compounds, for example, aromatic amine compounds of which the skeleton is an aromatic ring or triarylamine and which have been substituted with three or more amino groups at the aromatic nucleus (nuclei), or aromatic amine compounds of which the skeleton is an aromatic ring and which have been substituted with two or more aminomethyl groups at the aromatic nucleus (nuclei), it is possible to form a uniform organic film, thereby improving the thermal stability and uniformity of light emission of the organic EL device. The present inventors thus attained to the present invention.

The present invention provides an organic electroluminescence device comprising either

(a) a luminous layer containing a luminous material and a hole transport material, the weight ratio of the luminous material to the hole transport material being from 0.1:100 to 3:1; or

(b) a luminous layer containing a luminous material and a hole transport layer containing a hole transport material,

between a pair of electrodes at least one of which is transparent or translucent,

wherein the hole transport material contains an aromatic amine of formula (1), (2), (3) or (4);

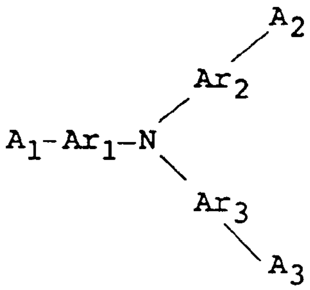

(1)

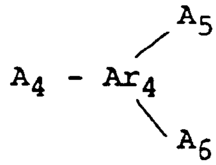

(2)

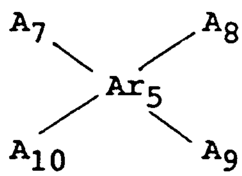

(3)

and

$$Ar_6(CH_2 - A_{11})_x \qquad (4)$$

wherein the groups $Ar_1$, $Ar_2$, $Ar_3$, $Ar_4$, $Ar_5$ and $Ar_6$ are independently selected from aromatic hydrocarbon groups having six or more carbon atoms and aromatic heterocyclic groups having four or more carbon atoms, x in formula (4) is an integer of 2 or more and the groups $(CH_2\text{-}A_{11})$ are the same or different, and the groups $A_1$, $A_2$, $A_3$, $A_4$, $A_5$, $A_6$, $A_7$, $A_5$, $A_9$, $A_{10}$ and $A_{11}$ are independently selected from the groups of formulae (5) to (13):

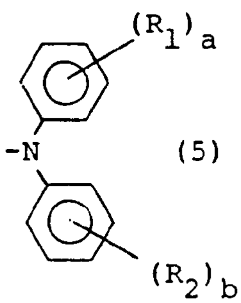

(5) ,

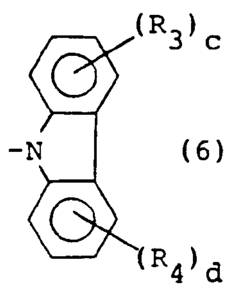

(6) ,

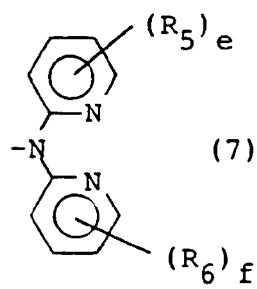

(7) ,

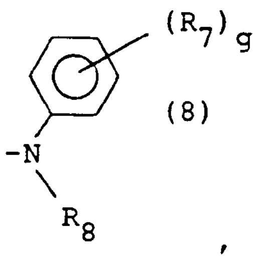

(8) ,

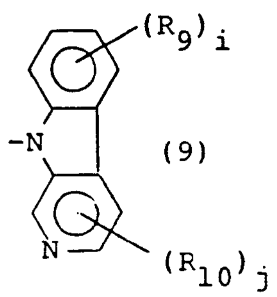

(9) ,

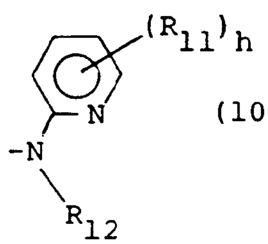

(10) ,

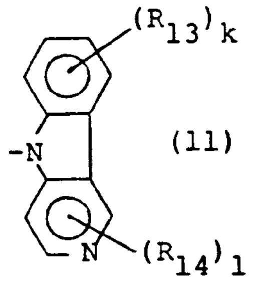 (11) ,

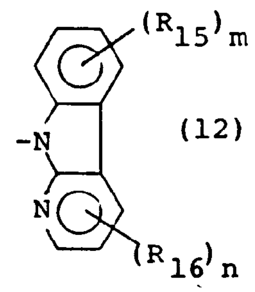 (12)

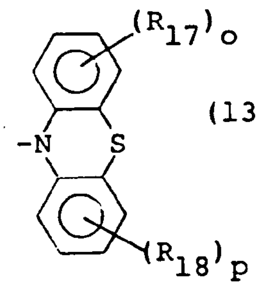 (13)

wherein each of $R_1$ to $R_7$, $R_9$ to $R_{11}$ and $R_{13}$ to $R_{18}$ is independently selected from $C_1$-$C_{12}$ alkyl and alkoxy groups, $C_6$-$C_{14}$ aryl and aryloxy groups, nitro and aromatic heterocyclic groups, $R_8$ and $R_{12}$ are each hydrogen or $C_1$-$C_{12}$ alkyl and a, b, c, d, e, f, g, h, i, j, k, l, m, n, o and p are integers of $0 \leqq$ a, b, g $\leqq 5$, $0 \leqq$ c, d, e, f, h, i, k, m, o, p $\leqq 4$ and $0 \leqq$ j, l, n $\leqq 3$.

In the present invention, as luminous materials for organic EL devices, known ones can be used without particular limitation. For example, dyes such as naphthalene derivatives, anthracene derivatives, perylene derivatives, polymethine dyes, xanthene dyes, coumarin dyes, cyanine dyes, etc., metal complexes of 8-hydroxyquinoline and its derivatives, aromatic amines, tetraphenylcyclopentadiene and its derivatives, tetraphenylbutadiene and its derivatives and known compounds described in US Patent No. 4,539,507 are mentioned.

Further, fluorescent conjugated polymers such as poly(p-phenylenevinylene), poly(2,5-diheptyloxy-p-phenylenevinylene), etc. having a short conjugated chain described in EP No. 0443861 also can be used.

Using these luminous materials, the luminous layer can be formed by properly selecting known methods, for example, vacuum deposition methods and coating methods such as spin coating, casting, dipping, bar coating and roll coating methods which use solutions of these luminous materials in solvents, according to the compounds used. When the luminous materials are not a high molecular compound, the vacuum deposition method is preferably used in carrying out fine control of film thickness.

The hole transport material used in the present invention is selected from the foregoing aromatic amine compounds represented by the formulae (1), (2), (3) and (4). In the aromatic amine compounds represented by the formulae (1), each of $Ar_1$, $Ar_2$ and $Ar_3$ independently represents a group selected from the group consisting of aromatic hydrocarbon groups having six or more carbon atoms and aromatic heterocyclic groups having four or more carbon atoms. The groups $Ar_1$, $Ar_2$ and $Ar_3$ may be different from one another, but in terms of ease of synthesis, two or more of them are preferably the same, and all of them are more preferably the same. The aromatic hydrocarbon groups having six or more carbon atoms that each of $Ar_1$, $Ar_2$ and $Ar_3$ represents include those bonded at two positions of the skeleton such as benzene, biphenyl, naphthalene or anthracene. More specifically, there are given 1,4-phenylene, 1,3-phenylene, 1,2-phenylene, 4,4′-biphenylene, 1,4-naphthalenediyl, 2,6-naphthalenediyl and 9,10-anthracenediyl. The aromatic heterocyclic groups having four or more carbon atoms include those bonded at two positions of the skeleton such as thiophene, pyridine or quinoline. More specifically, there are given 2,5-thienylene, 2,3-pyridinediyl, 2,4-pyridinediyl, 2,5-pyridinediyl, 2,3-quinolinediyl, 2,6-quinolinediyl and the like. Among these groups described above, from the standpoints of synthesis being easy and high-melting temperature compounds being given, 1,4-phenylene, 4,4′ -biphenylene, 2,6-naphthalenediyl, 9,10-anthracenediyl, 2,5-thienylene, 2,5-pyridinediyl and 2,6-quinolinediyl are preferred, and 1,4-phenylene, 4,4′-biphenylene, 2,6-naphthalenediyl, 9,10-anthracenediyl and 2,5-pyridinediyl are more preferred.

In the aromatic amine compounds represented by the formulae (2) and (3), each of $Ar_4$ and $Ar_5$ represents aromatic hydrocarbon groups having six or more carbon atoms or aromatic heterocyclic groups having four or more carbon atoms. The aromatic hydrocarbon groups having six or more carbon atoms include 1,2,4-benzenetriyl, 1,3,5-benzenetriyl, 1,2,4-naphthalenetriyl, 1,3,5-naphthalenetriyl, 2,3,6-naphthalenetriyl, 3,5,4′-biphenyltriyl, 1,2,4,5- benzenetetrayl, 2,3,6,7-naphthalenetetrayl and 3,4,3′,4′-biphenyltetrayl. The aromatic heterocyclic groups having four or more carbon atoms include 2,4,6-pyridinetriyl and 2,4,6-pyrimidinetriyl. Among these, more preferred ones are 1,3,5-benzenetriyl, 1,3,5-naphthalenetriyl, 2,3,6-naphthalenetriyl, 3,5,4′-biphenyltriyl, 2,4,6-pyridinetriyl and 2,3,6,7-naphthalenetetrayl. In the aromatic amine compounds represented by the formulae (1), (2) and (3), $A_1$ to $A_{10}$ are a diphenylamino group, N-carbazolyl group, di-2-pyridylamino group, N-alkyl-N-phenylamino group, N-alkyl-N-2-pyridylamino group, N-pyrimido[3,4-b]indolyl group, N-pyrimido[4,5-b]indolyl group, N-pyrimido[2,3-b]indolyl group and N-phenothiazinyl group represented by the formulae (5) to (13), respectively, as described above and derivatives of these groups in which the nucleus of each groups has been substituted with a $C_1$-$C_{12}$ alkyl or alkoxy group, $C_6$-$C_{14}$ aryl or aryloxy group, nitro group

or aromatic heterocyclic group. Each of $R_8$ and $R_{12}$ independently represents a hydrogen atom or a $C_1$-$C_{12}$ alkyl group. Of these groups, a diphenylamino, N-carbazolyl and di-2-pyridylamino groups and their derivatives having a good film-forming property are preferred.

In the aromatic amine compounds represented by the formula (4), a group $Ar_6$ includes those having two or more $\{CH_2 - A_{11})$ groups at the skeleton of benzene, naphthalene, anthracene, biphenyl, fluorene, phenanthrene, quinoline or quinoxaline. Of these, benzene and biphenyl are preferred in terms of ease of reaction. The $A_{11}$ group is selected from the groups represented by the foregoing formulae (5) to (13). Specifically, there are given a diphenylaminomethyl group, N-carbazolylmethyl group, di-2-pyridylaminomethyl group, N-alkyl-N-phenylaminomethyl group, N-alkyl-N-2-pyridylaminomethyl group, N-pyrimido[3,4-b]indolylmethyl group, N-pyrimido[4,5-b]indolylmethyl group, N-pyrimido[2,3-b]indolylmethyl group, N-phenothiazinylmethyl group and derivatives of these groups in which the aromatic ring (nucleus) of each group has been substituted with a $C_1$-$C_{12}$ alkyl or alkoxy group, $C_6$-$C_{14}$ aryl or aryloxy group, nitro group or aromatic heterocyclic group. Each of $R_8$ and $R_{12}$ is independently selected from the group consisting of a hydrogen atom and a $C_1$-$C_{12}$ alkyl groups. Of these groups, those having a good film-forming property, i.e. a diphenylaminomethyl group and its derivatives, di-2-pyridylaminomethyl group and its derivatives and N-alkyl-N-phenylaminomethyl group and its derivatives are preferred. Hereupon, the above $C_1$-$C_{12}$ alkyl groups include for example methyl, ethyl, butyl and octyl groups, etc., among which methyl and ethyl groups are preferred. The $C_1$-$C_{12}$ alkoxy groups include methoxy, ethoxy, butoxy and heptyloxy groups, etc., among which methoxy and ethoxy groups are preferred. The aryl groups include a phenyl group, 4-$C_1$-$C_6$ alkylphenyl group (this means a phenyl group having a $C_1$-$C_6$ alkyl group at the 4-position), 4-$C_1$-$C_6$ alkoxyphenyl group (this means a phenyl group having a $C_1$-$C_6$ alkoxy group at the 4-position), 1-naphthalene group and 2-naphthalene group. The aryloxy groups include a phenoxy group, 4-$C_1$-$C_6$ alkylphenoxy group and 4-$C_1$-$C_6$ alkoxyphenoxy group. The aromatic heterocyclic group includes 2-thienyl, 2-pyridyl, 3-pyridyl and 4-pyridyl groups. And, alkyl groups in the N-alkyl-N-phenylamino groups and N-alkyl-N-2-pyridylamino group represented by the formulae (8) and (10), respectively, represents $C_1$-$C_{12}$ alkyl groups, among which methyl and ethyl groups are preferred.

In the above formula (4), there is no particular limitation to the number of aminomethyl substituents except that it is two or more. Usually, however, from the standpoint of ease of synthesis, the number of the aminomethyl substituents on the benzene ring is preferably 2 to 4, and that of the same substituents on the biphenyl group and condensed polycyclic compounds such as a naphthalene ring and an anthracene ring is preferably 2 to 6, particularly preferably 2 to 4.

Specifically, there are given amine compounds described below:

Compounds represented by the formulae ($B_1$) to ($B_{15}$),

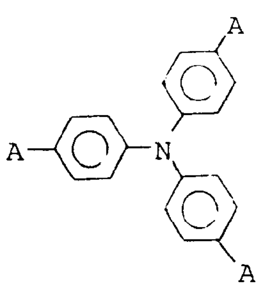 ($B_1$)

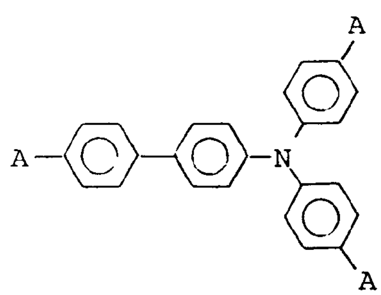 ($B_2$)

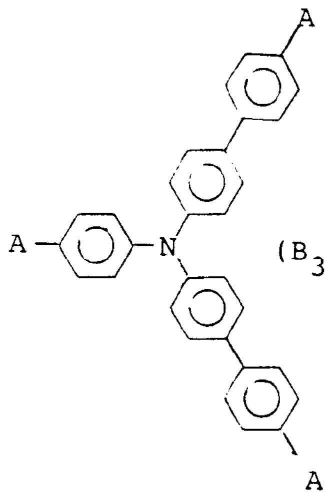
($B_3$)

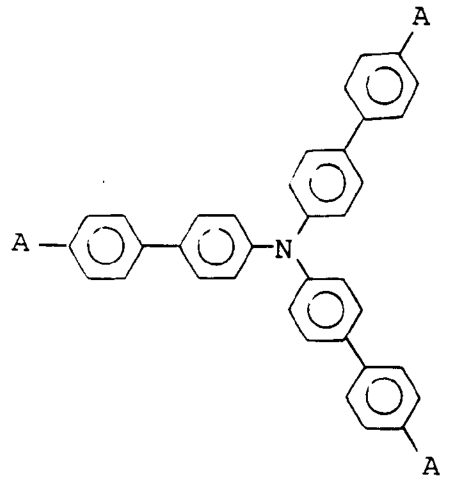
($B_4$)

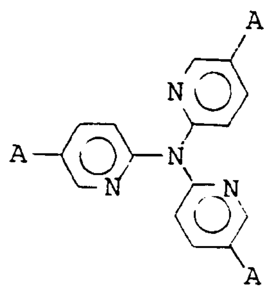
($B_5$)

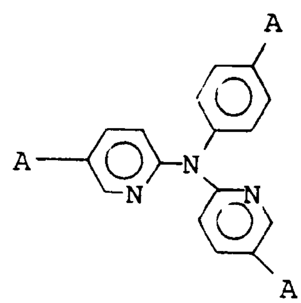
($B_6$)

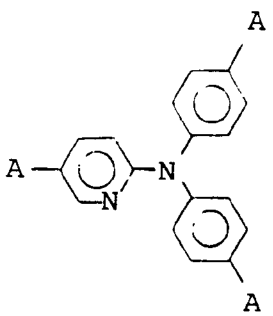
($B_7$)

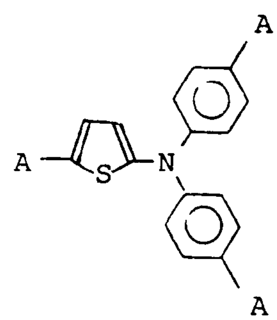
($B_8$)

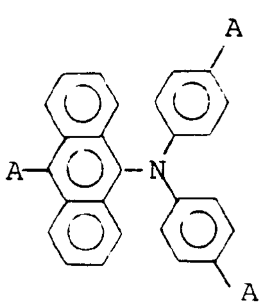
($B_9$)

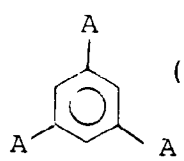
($B_{10}$)

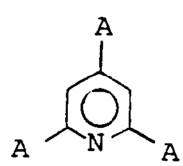
($B_{11}$)

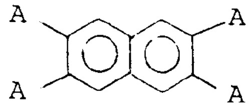
($B_{12}$)
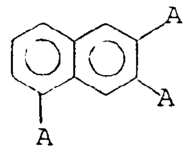
($B_{13}$)

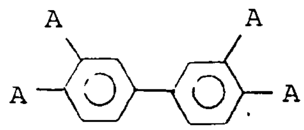
($B_{14}$)
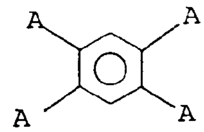
($B_{15}$)

wherein, in each case, the groups A are the same or different and each group A is selected from the groups of formulae ($D_1$) to ($D_6$),

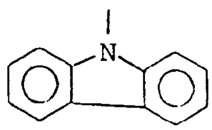
,
($D_1$)
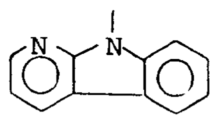
,
($D_2$)
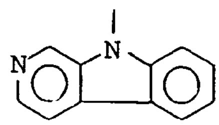
,
($D_3$)

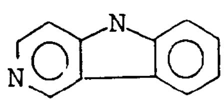
($D_4$)
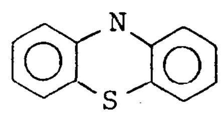
($D_5$)

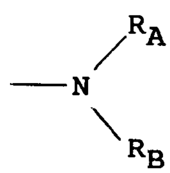
($D_6$)

wherein $R_A$ or $R_B$ are the same or different and are selected from, for example, methyl, ethyl, phenyl, 2-methylphenyl, 3-methylphenyl, 4-methylphenyl, 2-ethylphenyl, 3-ethylphenyl, 4-ethylphenyl, 4-tert-butylphenyl, 4-methoxyphenyl, 4-ethoxyphenyl, 2-nitrophenyl, 4-(phenyl)phenyl, 4-(2-thienyl)phenyl, 4-(4'methylphenyl)phenyl, 2-thienyl and 2-pyridyl, but $R_A$ is neither methyl nor ethyl when $R_B$ is methyl or ethyl. Specific examples of combinations of $R_A$ and $R_B$ in the formula ($D_6$) are listed in Table 1.

Table 1

| $-R_A$ | $-R_B$ |
|---|---|
| Phenyl | Phenyl |
| 2-Methylphenyl | 2-Methylphenyl |
| 3-Methylphenyl | 3-Methylphenyl |
| 4-Methylphenyl | 4-Methylphenyl |
| 2-Ethylphenyl | 2-Ethylphenyl |
| 3-Ethylphenyl | 3-Ethylphenyl |
| 4-Ethylphenyl | 4-Ethylphenyl |
| 4-Tert-butylphenyl | 4-Tert-butylphenyl |
| 4-Methoxyphenyl | 4-Methoxyphenyl |
| 4-Ethoxyphenyl | 4-Ethoxyphenyl |
| 2-Nitrophenyl | 2-Nitrophenyl |
| 4-(Phenyl)phenyl | 4-(Phenyl)phenyl |
| 4-(2-Thienyl)phenyl | 4-(2-Thienyl)phenyl |
| 4-(4'-Methylphenyl)phenyl | 4-(4'-Methylphenyl)phenyl |
| 2-Thienyl | 2-Thienyl |
| Phenyl | Methyl |
| Phenyl | Ethyl |
| Phenyl | 2-Methylphenyl |
| Phenyl | 3-Methylphenyl |
| Phenyl | 4-Methylphenyl |
| Phenyl | 2-Ethylphenyl |

| | |
|---|---|
| Phenyl | 3-Ethylphenyl |
| Phenyl | 4-Ethylphenyl |
| Phenyl | 4-Tert-butylphenyl |
| Phenyl | 4-Methoxyphenyl |
| Phenyl | 4-Ethoxyphenyl |
| Phenyl | 2-Nitrophenyl |
| Phenyl | 2-Pyridyl |
| Phenyl | 4-(Phenyl)phenyl |
| Phenyl | 4-(2-Thienyl)phenyl |
| Phenyl | 4-(4'-Methylphenyl)phenyl |
| Phenyl | 2-Thienyl |
| Methyl | 2-Methylphenyl |
| Methyl | 3-Methylphenyl |
| Methyl | 4-Methylphenyl |
| Methyl | 2-Ethylphenyl |
| Methyl | 3-Ethylphenyl |
| Methyl | 4-Ethylphenyl |
| Methyl | 4-Tert-butylphenyl |
| Methyl | 4-Methoxyphenyl |
| Methyl | 4-Ethoxyphenyl |
| Methyl | 2-Nitrophenyl |
| Methyl | 2-Pyridyl |
| Methyl | 4-(Phenyl)phenyl |
| Methyl | 4-(2-Thienyl)phenyl |
| Methyl | 4-(4'-Methylphenyl)phenyl |
| Methyl | 2-Thienyl |
| Ethyl | 2-Methylphenyl |
| Ethyl | 3-Methylphenyl |

| | |
|---|---|
| Ethyl | 4-Methylphenyl |
| Ethyl | 2-Ethylphenyl |
| Ethyl | 3-Ethylphenyl |
| Ethyl | 4-Ethylphenyl |
| Ethyl | 4-Tert-butylphenyl |
| Ethyl | 4-Methoxyphenyl |
| Ethyl | 4-Ethoxyphenyl |
| Ethyl | 2-nitrophenyl |
| Ethyl | 2-Pyridyl |
| Ethyl | 4-(Phenyl)phenyl |
| Ethyl | 4-(2-Thienyl)phenyl |
| Ethyl | 4-(4'-methylphenyl)phenyl |
| Ethyl | 2-Thienyl |
| 2-Pyridyl | 2-Pyridyl |
| 2-Pyridyl | 2-Methylphenyl |
| 2-Pyridyl | 3-Methylphenyl |
| 2-Pyridyl | 4-Methylphenyl |
| 2-Pyridyl | 2-Ethylphenyl |
| 2-Pyridyl | 3-Ethylphenyl |
| 2-Pyridyl | 4-Ethylphenyl |
| 2-Pyridyl | 4-Tert-butylphenyl |
| 2-Pyridyl | 4-Methoxyphenyl |
| 2-Pyridyl | 4-Ethoxyphenyl |
| 2-Pyridyl | 2-Nitrophenyl |
| 2-Pyridyl | 4-(Phenyl)phenyl |
| 2-Pyridyl | 4-(2-Thienyl)phenyl |
| 2-Pyridyl | 4-(4'-Methylphenyl)phenyl |
| 2-Pyridyl | 2-Thienyl |

Further, there are given aromatic amines having a methyleneamine group represented by the formulae

($B_{16}$) to ($B_{33}$),

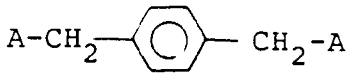

($B_{16}$)

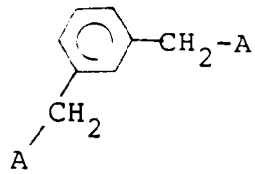

($B_{17}$)

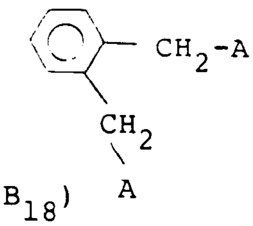

($B_{18}$)

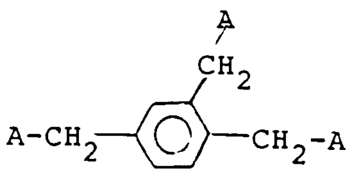

($B_{19}$)

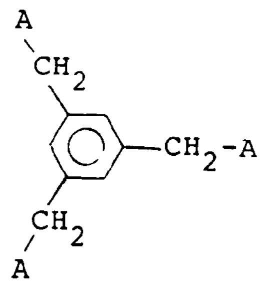

($B_{20}$)

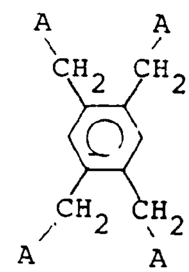

($B_{21}$)

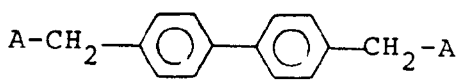

($B_{22}$)

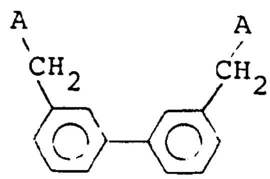

($B_{23}$)

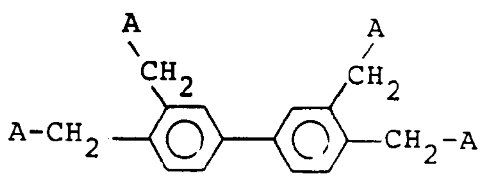

($B_{24}$)

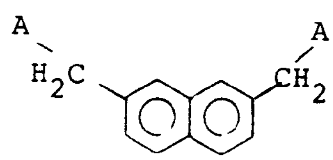

($B_{25}$)

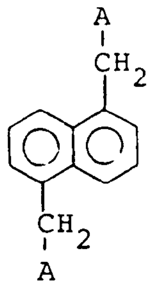

($B_{26}$)

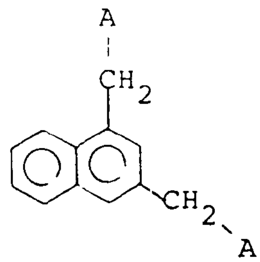

($B_{27}$)

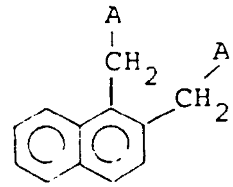

($B_{28}$)

($B_{29}$)

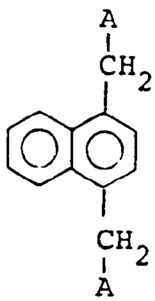

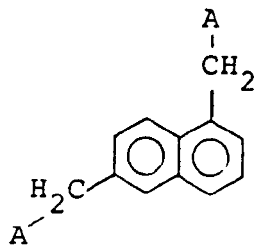

($B_{30}$)

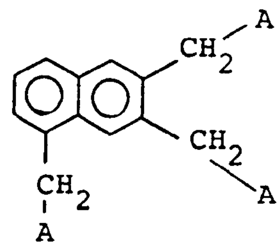

($B_{31}$)

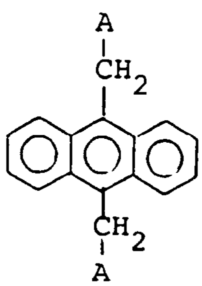

($B_{32}$)

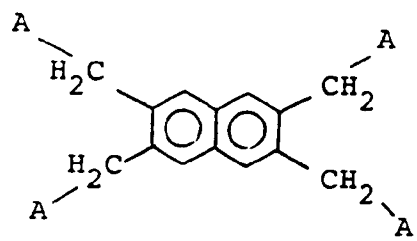

($B_{33}$)

wherein, in each case, the groups A are the same or different and each group A is selected from the groups of the foregoing formulae ($D_1$) to ($D_6$), the combination of $R_A$ and $R_B$ in ($D_6$) being specifically given in Table 1.

There is no particular limitation to a synthetic method for the aromatic amino compounds represented by the foregoing formulae (1), (2) and (3). Synthetic methods for these compounds will be shown below. Among the compounds represented by the formula (1), N,N,N-triphenylamine derivatives can be synthesized by adding KI, $KIO_3$ and acetic acid to triphenylamine to substitute iodine for hydrogen of the phenyl rings and reacting the resulting iodine-substituted product with the corresponding secondary amine compound and carbazole derivative. Among the compounds represented by the formula (2), 1,3,5-tris(diphenylamino)benzene derivatives can be synthesized by reacting 1,3,5-triiodobenzene with the corresponding secondary amine compound and carbazole derivative. Among the compounds represented by the formula (3), 3,4,3',4'-tetra(diphenylamino)biphenyl derivatives can be synthesized by reacting 3,4,3',4'-tetraiodobiphenyl with the corresponding secondary amine compound and carbazole derivative. Other compounds can likewise be synthesized by making use of these reactions.

There is also no particular limitation to a synthetic method for the aromatic amine compounds represented

by the formula (4), it being possible to make use of the known methods. for example, they can be synthesized by reacting an aromatic compound or its derivative having a halogenomethyl substituent at the predetermined position with the corresponding secondary amine compound or carbazole derivative.

When these compound are used as the hole transport layer of organic EL devices, it is desirable to purify them by reprecipitation, sublimation, etc. after synthesis because their purity affects the emission efficiency.

The hole transport layer containing the above aromatic amine compound can be formed by known methods, for example, vacuum deposition methods and coating methods such as spin coating, casting, dipping, bar coating and roll coating methods in which use solutions of the aromatic amine compounds are used. When the thin film of the layer is formed by the coating methods, it is desirable to apply heat-treatment at a temperature of 30° to 200°C, preferably 60° to 100°C under reduced pressure or in an inert gas atmosphere in order to remove the solvent. From the stand-point of carrying out fine control of the film thickness, to use the vacuum evaporation method is desirable. In producing the hole transport layer, the above aromatic amine compounds can be used alone or in mixture of two or more of them.

As far as the objects of the present invention are achieved, a mixture of the above hole transport aromatic amine compound and known hole transport compound may be used for the hole transport layer of the present invention. In this case, in order to make the formed hole transport layer thermally stable, the content of the above aromatic amine compound is usually 1 wt.% or more, preferably 10 wt.% or more, more preferably 30 wt.% or more based on the known hole transport compound.

The known hole transport compound is not critical, but there are given for example triphenyldiamine derivatives, oxadiazole derivatives, pyrazoline derivatives, arylamine derivatives, stilbene derivatives and the like. Specifically, there are given those described, for example, in US patent No. 4,539,507.

Since the thickness of the hole transport layer depends also upon the kind of the compounds used, it will suffice to properly determine the thickness taking that into account so as not to disturb sufficient development of the film-forming property and emission efficiency.

In the present invention, a layer in which the hole transport aromatic amine compound has been dispersed in a known polymer may also be used. The particular polymer used is not critical, but those which do not disturb the hole transport property are preferred. For example, there are given poly(N-vinylcarbazole), polyaniline and its derivatives, polythiophene and its derivatives, poly(p-phenylenevinylene) and its derivatives, poly(2,5-thienylenevinylene) and its derivatives, polycarbonate, polysiloxane, vinyl polymers such as polymethyl acrylate, polymethyl methacrylate, polystyrene and polyvinyl chloride, and polyethersulfone and the like.

Hereupon, the above poly(N-vinylcarbazole), polyaniline and its derivatives, polythiophene and its derivatives, poly(p-phenylenevinylene) and its derivatives and poly(2,5-thienylenevinylene) and its derivatives act also as the hole transport compound.

The layer of mixture of the polymer and the aromatic amine compound can be formed by mixing the polymer and the compound in a solution state or molten state to disperse the compound in the polymer and then applying the above coating methods. In this case, there is no particular limitation to the amount of the aromatic amine compound to be mixed with the polymer, but it is usually 1 to 200 parts by weight, preferably 10 to 100 parts by weight based on 100 parts by weight of the polymer.

When the polymeric precursors of poly(p-phenylenevinylene) and its derivatives and poly(2,5-thienylenevinylene) and its derivatives are used, the precursor and the aromatic amine compound are mixed in a solution state, and the mixture is heat-treated at a temperature of 30° to 300°C, preferably 60° to 200°C in an inert gas atmosphere to convert the precursor to the polymer.

In the present invention, it is also possible to use a layer in which the hole transport aromatic amine compound and the luminous material have been dispersed in a known polymer.

The mixing ratio of the luminous material and hole transport material is not critical, but preferably it is in the range of 0.1:100 to 3:1 (weight ratio). The mixing ratio of the polymer and the sum of these materials also is not critical, but preferably it is in the range of 100:0.01 to 1:3 (weight ratio).

In this case, the polymer preferably used is those which are described above and have not a strong absorption to visible lights. Specifically, there are given poly(N-vinylcarbazole), polythiophene and its derivatives, poly(p-phenylenevinylene) and its derivatives, poly(2,5-thienylenevinylene) and its derivatives, polycarbonate, polymethyl acrylate, polymethyl methacrylate, polystyrene, polyvinyl chloride, polysiloxane and the like. for forming the mixture layer, the same coating methods as described above can be employed. These layers thus formed may be used alone, but if necessary, may be used in combination with layers of other hole transport or electron transport materials.

The structure of the organic EL device of the present invention will be illustrated below. The structure of the device, in addition to ones described hereinbefore, i.e. anode/hole transport layer/luminous layer/cathode (symbol "/" means laying layers one upon another) and anode/hole transport-luminous layer/cathode, may take a combined structure having an electro-conductive polymer layer (as a buffer layer) between the anode and

hole transport layer and a combined structure having an electron transport layer between the luminous layer and cathode. further, the structure of the device may also take a structure of anode/electro-conductive polymer layer/hole transport layer/luminous layer/electron transport layer/cathode. In some cases, it is also possible to form the respective hole transport layers of different hole transport materials and properly lay these layers one upon another, or properly lay the luminous layer(s) and hole transport layer(s) in two or more layers one upon another. Thus, modification is possible within the scope of the present invention.

A method for producing the organic EL device will be illustrated with reference to the structure of anode/hole transport layer/luminous layer/cathode.

A transparent or translucent electrodes is formed on a transparent substrate such as glass, transparent plastics and the like, and used as an anode. A material for the electrode used includes electro-conductive metal oxide films, translucent metallic thin films and the like. Specifically, indium tin oxide (ITO), tin oxide (NESA), Au, Pt, Ag, Cu, etc. are used. for producing the electrode, methods such as vacuum deposition, sputtering, plating and the like are used.

Next, the foregoing hole transport layer is formed, and its thickness is 0.5 nm to 10 μm, preferably 1 nm to 1 μm. A thickness ranging from 2 to 200 nm is preferred in order to raise the luminance of emitted light by increasing current density.

Next, the luminous layer is formed on the hole transport layer, and its thickness needs to be such as to generate no pin holes. A too large thickness, however, is not preferred because it increases the resistance of the device to make a high driving voltage necessary. Consequently, the thickness of the luminous layer is 0.5 nm to 10 μm, preferably 1 nm to 1 μm, more preferably 5 to 200 nm.

This range of thickness is also preferred for the mixture layer of the hole transport material and luminous material.

Next, an electrode is formed on the luminous layer, as an electron-injecting cathode. Materials for the electrode are not critical, but materials of low work function are preferred. for example, Al, In, Mg, Mg/Ag alloy, Mg/In alloy, graphite thin film and the like are used. for producing the cathode, known methods such as vacuum deposition, sputtering and the like are used.

The organic EL device of the present invention can be produced by the method described above, but ones having other structures also can be produced by the similar method.

The aromatic amine compounds used as the hole transport material in the present invention have relatively high melting point and decomposition temperature, so that they are thermally stable.

The organic EL device with the hole transport material of the present invention, as compared with the conventional ones, has improved thermal stability and shows excellent emission characteristics, so that it can preferably be used in flat light sources as back light and display devices (e.g. flat panel display) and the like.

The present invention will be illustrated specifically with reference to the following examples, which are not however to be interpreted as limiting the invention thereto.

Example 1

On a glass substrate, to which an ITO film of 20 nm in thickness was previously applied by sputtering, was formed a hole transport layer by vacuum-depositing 4,4',4''-tris(diphenylamino)triphenylamine (hereinafter referred to as TDATA) in a thickness of 50 nm under a vacuum of 4 x $10^{-4}$ Pa (3 x $10^{-6}$ Torr). Thereafter, a luminous layer was formed thereon by vacuum-depositing tris(8-quinolinol)aluminum (hereinafter referred to as $Alq_3$) in a thickness of 80 nm, and then a cathode was further formed thereon by vacuum-depositing indium in a thickness of 600 nm. Thus, the organic EL device was produced. All the pressures at the time of vacuum deposition were 4 x $10^{-4}$ Pa (3 x $10^{-6}$ Torr) or less.

On applying a voltage of 25 V to this device, a current density of 208 mA/cm$^2$ and emission of green EL having a luminance of 210 cd/m$^2$ were observed. The luminance was directly proportional to the current density.

This device was put in a constant-temperature vessel, and a change in EL was observed while raising the temperature of the vessel. The device with TDATA as hole transport material continued to emit light even at a temperature over 100°C with its reduction in luminance being gently suppressed.

Example 2

On a glass substrate, to which an ITO film of 40 nm in thickness was previously applied by sputtering, was formed a hole transport layer by vacuum-depositing TDATA in a thickness of 40 nm under a vacuum of 3 x $10^{-6}$ Torr. Thereafter, a luminous layer was formed thereon by vacuum-depositing $Alq_3$ in a thickness of 40 nm, and then a cathode was further formed thereon by vacuum-depositing a Mg/Ag ally (weight ratio, Mg : Ag

= 10 : 1) in a thickness of 200 nm. Thus, the organic EL device was produced. All the pressures at the time of vacuum deposition were 5.3 x $10^{-4}$ Pa (4 x $10^{-6}$ Torr) or less. On applying a voltage of 11 V to this device, a current density of 295 mA/$cm^2$ and emission of green EL having a luminance of 820 cd/$m^2$ were observed. The luminance was directly proportional to the current density. On observing electroluminescence while heating this device in vacuum, emission of light having a luminance of 12 cd/$m^2$ was observed even at 130°C.

Example 3

On a glass substrate, to which an ITO film of 20 nm in thickness was previously applied by sputtering, was formed a hole transport layer in a thickness of 50 nm by spin coating of an N,N-dimethylformamide solution containing 0.5 wt.% of a mixture comprising the same weights of TDATA and polyaniline and then drying under reduced pressure. Thereafter, a luminous layer was formed thereon by vacuum-depositing $Alq_3$ in a thickness of 80 nm, and then a cathode was further formed thereon by vacuum-depositing indium in a thickness of 600 nm. Thus, the organic EL device was produced. Vacuum deposition was continuously carried out without breaking vacuum. All the pressures at the time of vacuum deposition were 4 x $10^{-4}$ Pa (3 x $10^{-6}$ Torr) or less. On applying a voltage of 25 V to this device, a current density of 90 mA/$cm^2$ and emission of green EL having a luminance of 98 cd/$m^2$ were observed. The luminance was directly proportional to the current density. This device was put in a constant-temperature vessel, and a change in EL was observed while raising the temperature of the vessel. The device with TDATA as charge transport material continued to emit light even at a temperature over 100°C with its reduction in luminance being gently suppressed.

Example 4

A chloroform solution containing 0.5 wt.% of a mixture comprising TDATA, $Alq_3$ and polycarbonate in a weight ratio of 1.75 : 1.25 : 7 was prepared. On a glass substrate, to which an ITO film of 20 nm in thickness was previously applied by sputtering, a film was formed in a thickness of 170 nm by spin coating of the above solution and then drying under reduced pressure. Thereafter, a cathode was formed thereon by vacuum-depositing indium in a thickness of 600 nm to produce an organic EL device. Vacuum deposition was continuously carried out under reduced pressure without breaking vacuum. All the pressures at the time of vacuum deposition were 4 x $10^{-4}$ Pa (3 x $10^{-6}$ Torr) or less. On applying a voltage of 52 V to this device, a current density of 31 mA/$cm^2$ and emission of green EL having a luminance of 2 cd/$m^2$ were observed. The luminance was directly proportional to the current density.

This device was put in a constant-temperature vessel, and a change in EL was observed while raising the temperature of the vessel. The device with TDATA as hole transport material continued to emit light even at a temperature over 100°C with its reduction in luminance being gently suppressed.

Example 5

On a glass substrate, to which an ITO film of 20 nm in thickness was previously applied by sputtering, was formed a hole transport layer by vacuum-depositing TDATA in a thickness of 50 nm. Thereafter, a luminous layer was formed thereon by co-vacuum-depositing $Alq_3$ and 4-dicyanomethylene-6-(p-dimethylaminostyryl)-2-methyl-4H-pirane (hereinafter referred to as DCM) in a weight ratio of about 20 : 1 in a thickness of 40 nm, and then a cathode was further formed thereon by vacuum-depositing a Mg/Ag alloy (weight ratio, Mg : Ag = 10 : 1) in a thickness of 200 nm. Thus, the organic EL device was produced. All the pressures at the time of vacuum deposition were 4 x $10^{-4}$ Pa (3 x $10^{-6}$ Torr) or less.

On applying a voltage of 13 V to this device, a current density of 120 mA/$cm^2$ and emission of red EL having a lumiannce of 32 cd/$m^2$ were observed. The EL spectrum agreed with the fluorescent spectrum of DCM. The luminance was directly proportional to the current density.

This device was put in a constant-temperature vessel, and a change in EL was observed while raising the temperature of the vessel. The device with TDATA as hole transport material continued to emit light even at a temperature over 100°C with its reduction in luminance being gently suppressed.

Example 6

On a glass substrate, to which an ITO film of 40 nm in thickness was previously applied by sputtering, was formed a hole transport layer by vacuum-depositing TDATA in a thickness of 50 nm under a vacuum of 4 x $10^{-4}$ Pa (3 x $10^{-6}$ Torr). Thereafter, a luminous layer comprising 1,1,4,4-tetraphenyl-1,3-butadiene (hereinafter referred to as TPB), an electron transport layer comprising $Alq_3$ and a cathode comprising a Mg/Ag alloy (weight

ratio, Mg : Ag = 10 : 1) were vacuum-deposited one upon another on the above hole transport layer in thickness of 20 nm, 40 nm and 200 nm, respectively. Thus, the organic EL device was produced. All the pressures at the time of vacuum deposition were 3 x $10^{-6}$ Torr or less.

On applying a voltage of 14.2 V to this device, a current density of 176 mA/$cm^2$ and emission of blue EL having a luminance of 89 cd/$m^2$ were observed. The EL spectrum agreed with the fluorescent spectrum of TPB. The luminance was directly proportional to the current density.

This device was put in a constant-temperature vessel, and a change in EL was observed while raising the temperature of the vessel. The device with TDATA as hole transport material continued to emit light even at a temperature over 100°C with its reduction in luminance being gently suppressed.

Example 7

On a glass substrate, to which an ITO film of 40 nm in thickness was previously applied by sputtering, was formed a hole transport layer by vacuum-depositing 4,4′,4″-tris(N-carbazolyl)triphenylamine in a thickness of 40 nm. Thereafter, a luminous layer was formed thereon by vacuum-depositing $Alq_3$ in a thickness of 40 nm, and then a cathode was further formed thereon by vacuum-depositing a Mg/Ag alloy (weight ratio, Mg : Ag = 10 : 1) in a thickness of 200 nm. Thus, the organic EL device was produced. All the pressures at the time of vacuum deposition were 5.3 x $10^{-4}$ Pa (4 x $10^{-6}$ Torr) or less.

On applying a voltage of 15 V to this device, a current density of 125 mA/$cm^2$ and emission of green EL having a luminance of 136 cd/$m^2$ were observed. The luminance was directly proportional to the current density.

This device was put in a constant-temperature vessel, and a change in EL was observed while raising the temperature of the vessel. The device with 4,4′,4″-tris(N-carbazolyl)triphenylamine as hole transport material continued to emit light even at 130°C.

Example 8

On a glass substrate, to which an ITO film of 40 nm in thickness was previously applied by sputtering, was formed a hole transport layer by vacuum-depositing 4,4′,4″-tris(di-2-pyridylamino)triphenylamine in a thickness of 40 nm. Thereafter, a luminous layer was formed thereon by vacuum-depositing $Alq_3$ in a thickness of 40 nm, and then a cathode was further formed thereon by vacuum-depositing a Mg/Ag ally (weight ratio, Mg : Ag = 10 : 1) in a thickness of 200 nm. Thus, the organic EL device was produced. All the pressures at the time of vacuum deposition were 5.3 x $10^{-4}$ Pa (4 x $10^{-6}$ Torr) or less.

On applying a voltage of 18 V to this device, a current density of 19.4 mA/$cm^2$ and emission of green EL having a luminance of 152 cd/$m^2$ were observed. The luminance was directly proportional to the current density.

On applying voltage to this device in vacuum with heating, emission of EL having a luminance of 44 cd/$m^2$ was observed even at 130°C.

Example 9

On a glass substrate, to which an ITO film of 20 nm in thickness was previously applied by sputtering, was formed a hole transport layer by vacuum-depositing 1,4-bis(N,N-diphenylaminomethyl)benzene in a thickness of 92 nm under a vacuum of 4 x $10^{-4}$ Pa (3 x $10^{-6}$ Torr). Thereafter, a luminous layer was formed thereon by vacuum-depositing $Alq_3$ in a thickness of 100 nm, and then a cathode was further formed thereon by vacuum-depositing indium in a thickness of 600 nm. Thus, the organic EL device was produced. All the pressures at the time of vacuum deposition were 4 x $10^{-4}$ Pa (3 x $10^{-6}$ torr) or less.

On applying a voltage of 30 V to this device, a current density of 79 mA/$cm^2$ and emission of green EL having a luminance of 42 cd/$m^2$ were observed. The luminance was directly proportional to the current density.

This device was heated to 80°C in vacuum, and the fluorescent spectrum of the heated device was measured with a fluorospectrophotometer (Fluorospectrophotometer Model 850 produced by Hitachi Ltd.). However, a large change in the peak intensity of the fluorescent spectrum was not observed. The melting point of 1,4-bis(N,N-diphenylaminomethyl)benzene was measured with SSC5020 Thermal Analysis System (produced by Seiko Instruments Inc.) to find that it was 176°C.

Example 10

On a glass substrate, to which an ITO film of 20 m in thickness was previously applied by sputtering, was

formed a hole transport layer by vacuum-depositing 1,2,4,5-tetrakis(N-methyl-N-phenylaminomethyl)benzene in a thickness of 99 nm under a vacuum of 3 x $10^{-6}$ Torr. Thereafter, a luminous layer was formed thereon by vacuum-depositing $Alq_3$ in a thickness of 100 nm, and then a cathode was further formed thereon by vacuum-depositing indium in a thickness of 600 nm. Thus, the organic EL device was produced. All the pressures at the time of vacuum deposition were 4 x $10^{-4}$ Pa (3 x $10^{-6}$ Torr) or less.

On applying a voltage of 32 V to this device, a current density of 20 mA/cm$^2$ and emission of green EL having a luminance of 35 cd/m$^2$ were observed. The luminance was directly proportional to the current density.

On applying voltage to this device in vacuum with heating, emission of EL having a luminance of 5 cd/m$^2$ was observed even at 100°C. This device was heated to 80°C in vacuum in the same manner as in Example 9, but a large change in the fluorescent spectrum was not observed. The melting point of 1,2,4,5-tetrakis(N-methyl-N-phenylaminomethyl)benzene was measured in the same manner as in Example 9 to find that it was 199°C.

Example 11

On a glass substrate, to which an ITO film of 20 nm in thickness was previously applied by sputtering, was formed a hole transport layer by vacuum-depositing 4,4'-bis(N,N-diphenylaminomethyl)biphenyl in a thickness of 60 nm under a vacuum of 4 x $10^{-4}$ Pa (3 x $10^{-6}$ Torr). Thereafter, a luminous layer was formed thereon by vacuum-depositing $Alq_3$ in a thickness of 40 nm, and then a cathode was further formed thereon by vacuum-depositing indium in a thickness of 600 nm. Thus, the organic EL device was produced. All the pressures at the time of vacuum deposition were 4 x $10^{-4}$ Pa (3 x $10^{-6}$ Torr) or less.

On applying a voltage of 30 V to this device, a current density of 3.6 mA/cm$^2$ and emission of green EL having a luminance of 11.7 cd/m$^2$ were observed. The luminance was directly proportional to the current density.

On applying voltage to this device in vacuum with heating, emission of EL having a luminance of 5 cd/m$^2$ was observed even at 100°C. This device was heated to 80°C in vacuum in the same manner as in Example 9, but a large change in the fluorescent spectrum was not observed. The melting point of 4,4'-bis(N,N-diphenylaminomethyl)biphenyl was measured in the same manner as in Example 9 to find that it was 232°C. The above results show that this organic EL device has a good thermal stability.

Example 12

On a glass substrate, to which an ITO film of 20 nm in thickness was previously applied by sputtering, was formed a hole transport layer by vacuum-depositing 1,2,4-tris(N,N-diphenylaminomethyl)benzene in a thickness of 60 nm under a vacuum of 4 x $10^{-4}$ Pa (3 x $10^{-6}$ Torr). Thereafter, a luminous layer was formed thereon by vacuum-depositing $Alq_3$ in a thickness of 40 nm, and then a cathode was further formed thereon by vacuum-depositing indium in a thickness of 600 nm. Thus, the organic EL device was produced. All the pressures at the time of vacuum deposition were 4 x $10^{-4}$ Pa (3 x $10^{-6}$ Torr) or less.

On applying a voltage of 43 V to this device, a current density of 1.2 mA/cm$^2$ and emission of green EL having a luminance of 25 cd/m$^2$ were observed. The luminance was directly proportional to the current density.

On applying voltage to this device in vacuum with heating, emission of EL having as luminance of 28 cd/m$^2$ was observed even at 80°C. This device was heated to 80°C in vacuum in the same manner as in Example 9, but a large change in the fluorescent spectrum was not observed.

Comparative Example 1

On a glass substrate, to which an ITO film of 20 nm in thickness was previously applied by sputtering, was formed a hole transport layer by vacuum-depositing 4,4'-bis[N-(3-methylphenyl)-N-phenylamino]biphenyl (hereinafter referred to as TPD) in a thickness of 50 nm under a vacuum of 4 x $10^{-4}$ Pa (3 x $10^{-6}$ Torr). Thereafter, a luminous layer was formed thereon by vacuum-depositing $Alq_3$ in a thickness of 80 nm, and then a cathode was further formed thereon by vacuum-depositing indium in a thickness of 600 nm. Thus, the organic EL device was produced. Vacuum deposition on every layer was continuously carried out under reduced pressure without breaking vacuum. All the pressures at the time of vacuum deposition were 4 x $10^{-4}$ Pa (3 x $10^{-6}$ Torr) or less.

On applying voltage to this device in vacuum with heating, emission of EL became very weak at 80°C, and there was no emission at all at 100°C.

After this device was heated to 60°C in vacuum, its fluorescent spectrum was measured in the same manner as in Example 9 to find that the intensity of the spectrum showed a great change as compared with that of the fluorescent spectrum at room temperature. The melting point of TPD was measured in the same manner

as in Example 9 to find that it was 169°C.

Comparative Example 2

An organic EL device outside the scope of the invention was produced for comparative purposes by the method described in Example 8, but using TPD as the hole transport material in place of 4,4′-4″-tris(di-2-pyridylamino)triphenylamine.

On applying voltage to this device in vacuum with heating, emission of EL became very weak at 80°C, and there was no emission at all at 100°C.

After this device was heated to 60°C in vacuum, its fluorescent spectrum was measured in the same manner as in Example 9 to find that the strength of the spectrum showed a great change as compared with that of the fluorescent spectrum at room temperature.

## Claims

1. An organic electroluminescence device comprising either
   (a) a luminous layer containing a luminous material and a hole transport material, the weight ratio of the luminous material to the hole transport material being from 0.1:100 to 3:1 ; or
   (b) a luminous layer containing a luminous material, and a hole transport layer containing a hole transport material,
   between a pair of electrodes at least one of which is transparent or translucent, wherein the hole transport material contains an aromatic amine of formula (1), (2), (3) or (4):

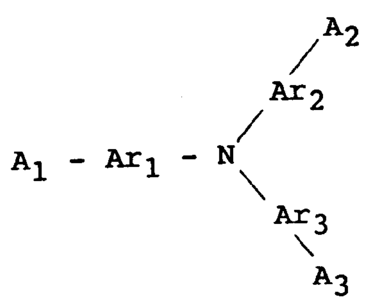

(1)

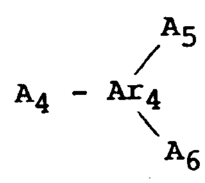

(2)

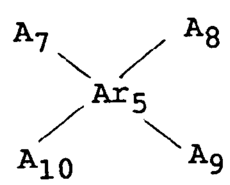

(3)

$Ar_6(CH_2 - A_{11})_x$ (4)

wherein the groups $Ar^1$, $Ar^2$, $Ar^3$, $Ar^4$, $Ar^5$ and $Ar^5$ are independently selected from aromatic hydrocarbon groups having six or more carbon atoms and aromatic heterocyclic groups having four or more carbon atoms, x in formula (4) is an integer of 2 or more and the groups ($CH_2$-$A_{11}$) are the same or different, and the groups $A^1$, $A^2$, $A^3$, $A^4$, $A^5$, $A^6$, $A^7$, $A^8$, $A^9$, $A^{10}$ and $A^{11}$, are independently selected from the groups of formulae (5) to (13):

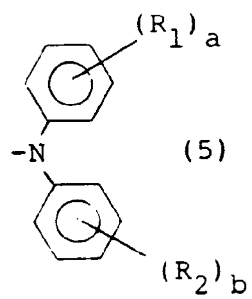
(5) ,

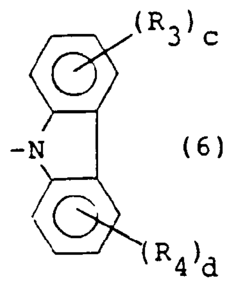
(6) ,

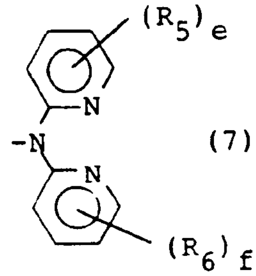
(7) ,

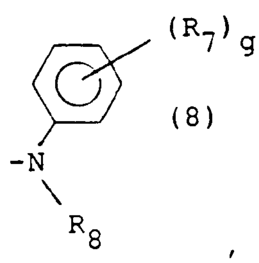
(8) ,

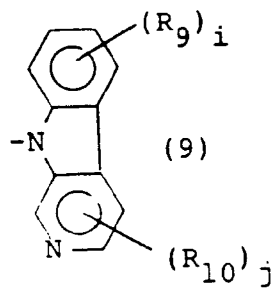
(9) ,

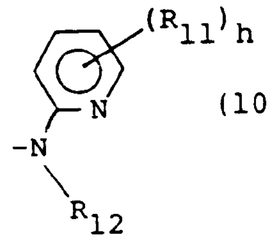
(10) ,

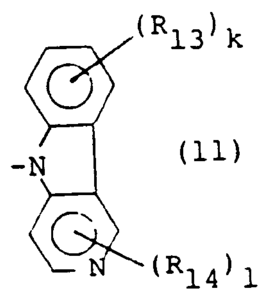
(11) ,

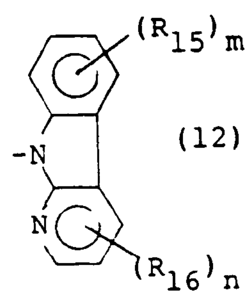
(12)

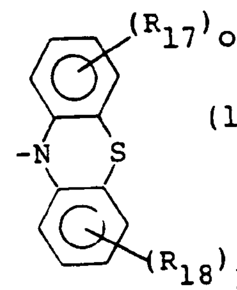
(13)

wherein each of $R^1$ to $R^7$, $R^9$ to $R^{11}$ and $R^{13}$ to $R^{18}$ is independently selected from $C_1$-$C_{12}$ alkyl and alkoxy groups, $C_6$-$C_{14}$ aryl and aryloxy groups, nitro and aromatic heterocyclic groups, $R^8$ and $R^{12}$ are each hydrogen or $C_1$-$C_{12}$ alkyl and a, b, c, d, e, f, g, h, i, j, k, l, m, n, o and p are integers of $0 \leqq$ a, b, g $\leqq 5$, $0 \leqq$ c, d, e, f, h, i, k, m, o, p $\leqq 4$ and $0 \leqq$ j, l, n $\leqq 3$.

2. A device according to claim 1 comprising a luminous layer and a hole transport layer wherein the hole transport layer is composed of a mixture of the aromatic amine compound and a polymer.

3. A device according to claim 2, wherein the hole transport layer comprises 1 to 200 parts by weight of the aromatic amine compound per 100 parts by weight of the polymer.

4. A device according to claim 1 (a) comprising a luminous material and a hole transport material dispersed in a polymer.

5. A device according to claim 4 wherein the weight ratio of the polymer to the sum of the luminous material and hole transport material is in the range of 100:0.01 to 1:3.

6. A device according to any one of claims 2 to 5, wherein the polymer is selected from polymers of N-vinylcarbazole, aniline and its derivatives, thiophene and its derivatives and p-phenylenevinylene and its derivatives, polycarbonates, polysiloxanes, vinyl polymers and polyethersulfones.

7. A device according to any one of claims 1 to 6 wherein the hole transport material is selected from the compounds of formulae $(B^1)$ to $(B^{15})$:

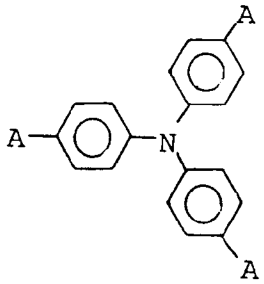

$(B_1)$

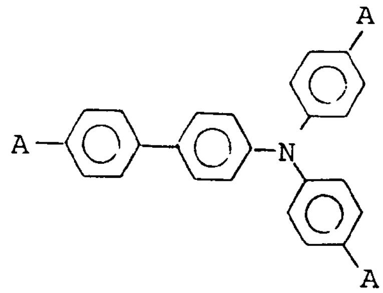

$(B_2)$

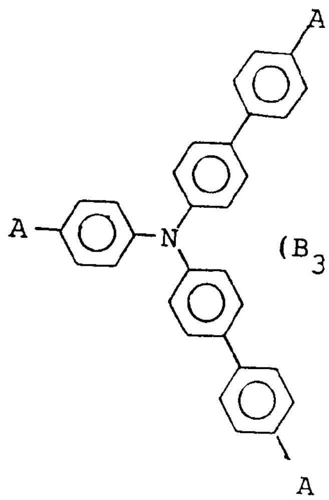

$(B_3)$

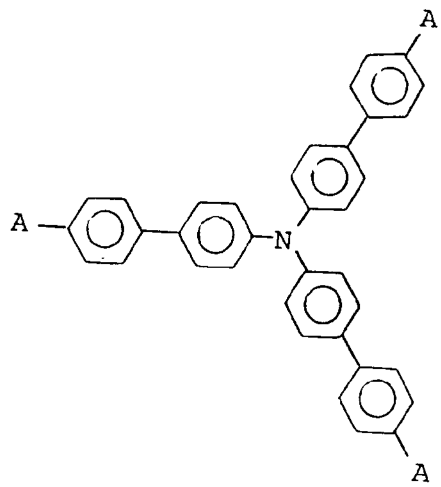

$(B_4)$

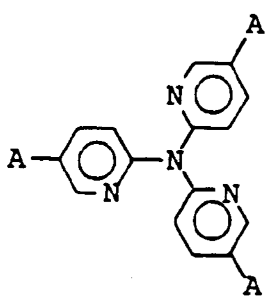

$(B_5)$

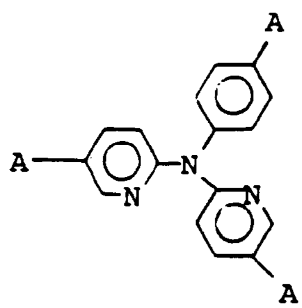

$(B_6)$

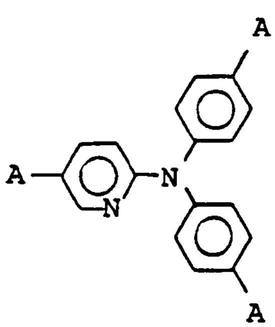

$(B_7)$

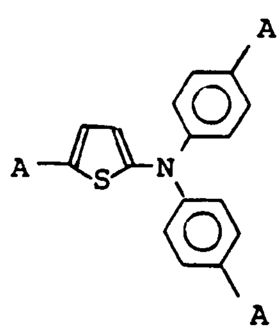

$(B_8)$

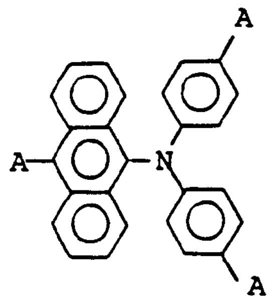
($B_9$)

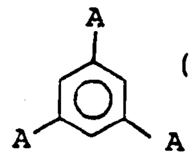
($B_{10}$)

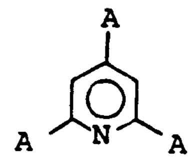
($B_{11}$)

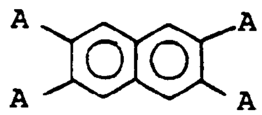
($B_{12}$)

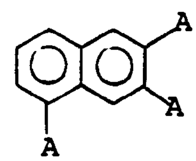
($B_{13}$)

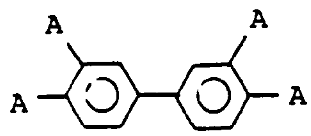
($B_{14}$)

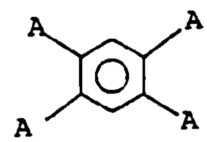
($B_{15}$)

wherein in each case the groups A are the same or different and each group A is selected from the groups of formulae ($D^1$) to ($D^6$):

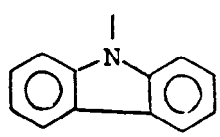
,
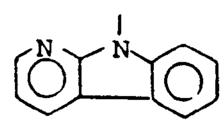
,
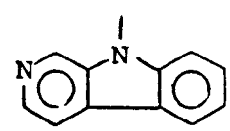

($D_1$) ($D_2$) ($D_3$)

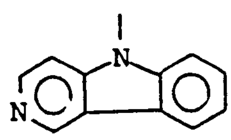
($D_4$)

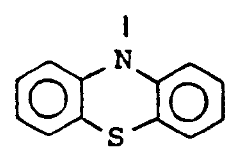
($D_5$)

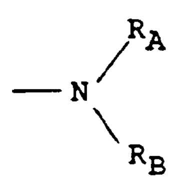
($D_6$)

wherein $R^A$ and $R^B$ are the same or different and each is methyl, ethyl, phenyl, 2-methylphenyl, 3-methylphenyl, 4-methylphenyl, 2-ethylphenyl, 3-ethylphenyl, 4-ethylphenyl, 4-tert-butylphenyl, 4-methoxyphenyl, 4-ethoxyphenyl, 2-nitrophenyl, 4-(phenyl)phenyl, 4-(2-thienyl)phenyl, 4-(4'-methylphenyl)phenyl, 2-thienyl or 2-pyridyl provided that $R^A$ is not methyl or ethyl when $R^B$ is methyl or ethyl.

8. A device according to claim 7 wherein the hole transport material is a compound of formula ($B^1$) wherein A is a group selected from the groups of formulae ($D^1$) to ($D^5$) and groups of formula ($D^6$) wherein $R^A$ is phenyl, 2-methylphenyl, 3-methylphenyl, 4-methylphenyl, 2-ethylphenyl, 3-ethylphenyl, 4-ethylphenyl, 4-tert-butylphenyl, 4-methoxyphenyl, 4-ethoxyphenyl, 2-nitrophenyl, 4-(phenyl)phenyl, 4-(2-thienyl)phenyl, 4-(4'-methylphenyl)phenyl, 2-thienyl or 2-pyridyl, and $R^B$ is 4-tert-butylphenyl, 4-methoxyphenyl, 4-ethoxyphenyl, 2-nitrophenyl, 4-(phenyl)phenyl, 4-(2-thienyl)phenyl, 4-(4'-methylphenyl)phenyl, 2-thienyl or 2-pyridyl.

9. A device according to any one of claims 1 to 6 wherein the hole transport material is selected from the compounds of formulae ($B^{16}$) to ($B^{33}$):

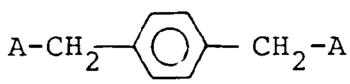

($B_{16}$)

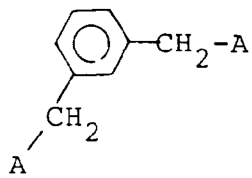

($B_{17}$)

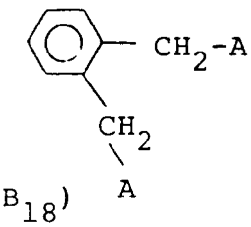

($B_{18}$)

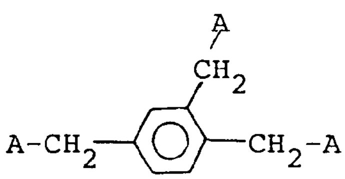

($B_{19}$)

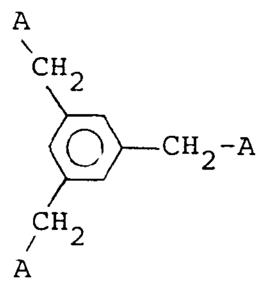

($B_{20}$)

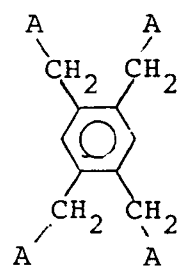

($B_{21}$)

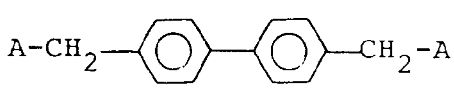

($B_{22}$)

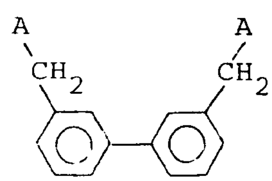

($B_{23}$)

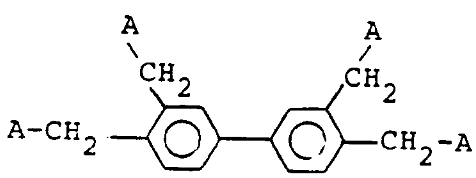

($B_{24}$)

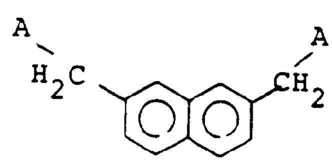

($B_{25}$)

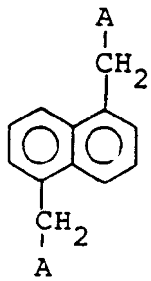

(B26)

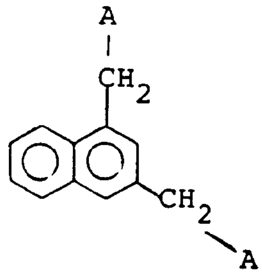

(B27)

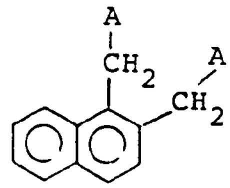

(B28)

(B29)

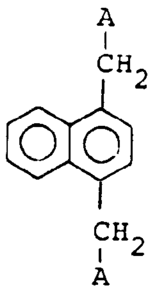

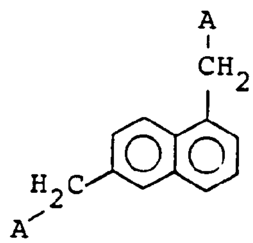

(B30)

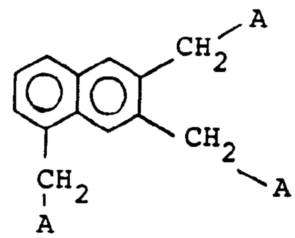

(B31)

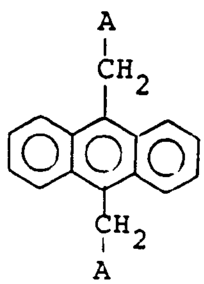

(B32)

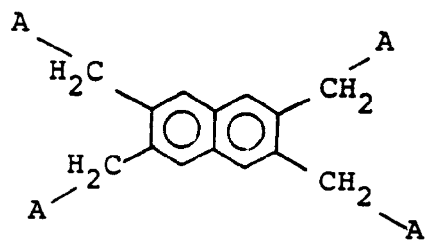

(B33)

wherein in each case the groups A are the same or different and each group A is selected from the groups of formulae ($D^1$) to ($D^6$).

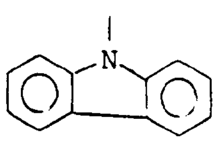

,

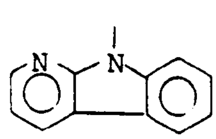

,

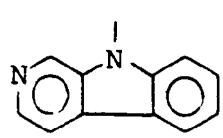

(D1) (D2) (D3)

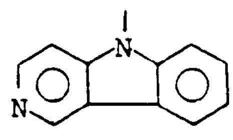

and

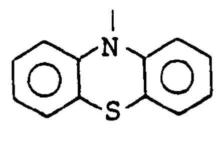

($D_4$)

($D_5$)

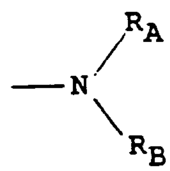

($D_6$)

wherein $R^A$ or $R^B$ are the same of different and each is methyl, ethyl, phenyl, 2-methylphenyl, 3-methylphenyl, 4-methylphenyl, 2-ethylphenyl, 3-ethylphenyl, 4-ethylphenyl, 4-tert-butylphenyl, 4-methoxyphenyl, 4-ethoxyphenyl, 2-nitrophenyl, 4-(phenyl)-phenyl, 4-(2-thienyl)phenyl, 4-(4′-methylphenyl)phenyl, 2-thienyl or 2-pyridyl provided $R^A$ is not methyl or ethyl when $R^B$ is methyl or ethyl.

## Patentansprüche

1. Organische elektrolumineszente Vorrichtung, umfassend entweder
(a) eine leuchtende Schicht, die eine leuchtende Substanz und eine Elektronenlückentransportsubstanz enthält, wobei das Gewichtsverhältnis der leuchtenden Substanz zur Elektronenlückentransportsubstanz 0,1: 100 bis 3 : 1 beträgt, oder
(b) eine leuchtende Schicht, die eine leuchtende Substanz enthält, und eine Elektronenlückentransportschicht, die eine Elektronenlückentransportsubstanz enthält, zwischen einem Paar von Elektroden, von denen mindestens eine transparent oder lichtdurchlässig ist, wobei das Elektronenlückentransportmaterial ein aromatisches Amin der Formel (1), (2), (3) oder (4) enthält:

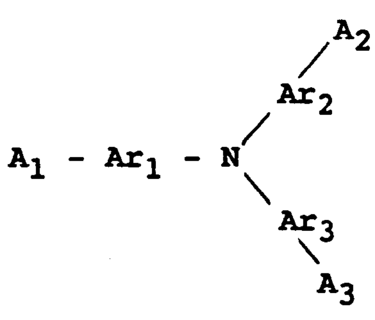

(1)

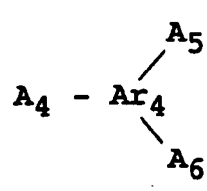

(2)

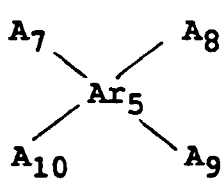

(3)

$$Ar_6(CH_2 - A_{11})_x \qquad (4)$$

in denen die Reste $Ar^1$, $Ar^2$, $Ar^3$, $Ar^4$, $Ar^5$ und $Ar^6$ unabhängig ausgewählt sind aus aromatischen Kohlenwasserstoffresten mit sechs oder mehr Kohlenstoffatomen und aromatischen heterocyclischen Resten mit vier oder mehr Kohlenstoffatomen, x in der Formel (4) eine ganze Zahl von 2 oder mehr ist und die

Reste ($CH_2$-$A_{11}$) gleich oder verschieden sind und die Reste $A^1$, $A^2$, $A^3$, $A^4$, $A^5$, $A^6$, $A^7$, $A^8$, $A^9$, $A^{10}$ und $A^{11}$ unabhängig ausgewählt sind aus Resten der Formeln (5) bis (13):

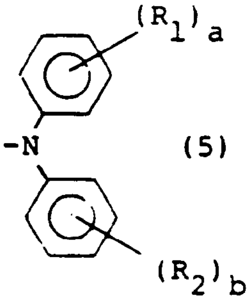 (5) , 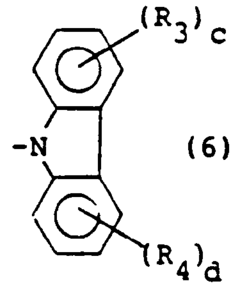 (6) , 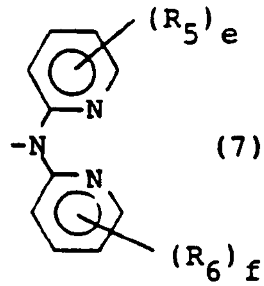 (7) ,

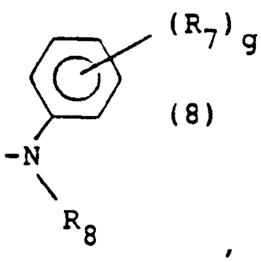 (8) , 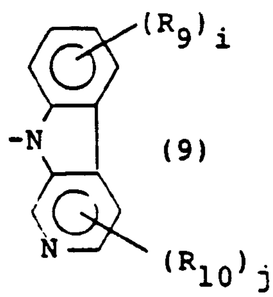 (9) , 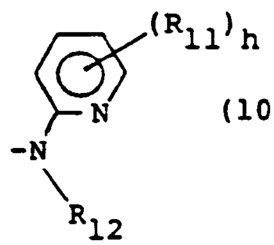 (10) ,

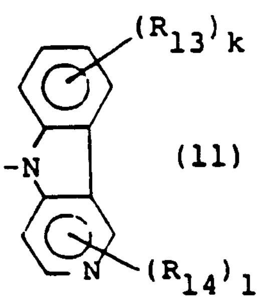 (11) , 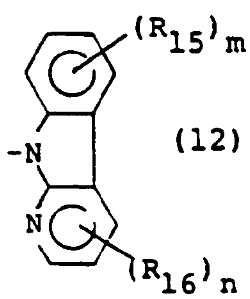 (12) 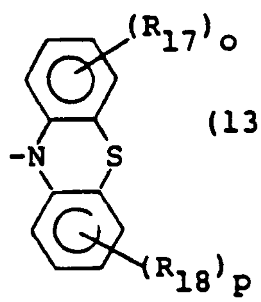 (13)

wobei jeder der Reste $R^1$ bis $R^7$, $R^9$ bis $R^{11}$ und $R^{13}$ bis $R^{18}$ unabhängig ausgewählt ist aus $C_1$-$C_{12}$-Alkyl- und Alkoxyresten, $C_6$-$C_{14}$-Aryl- und Aryloxyresten, Nitrogruppen und aromatischen heterocyclischen Resten, $R^8$ und $R^{12}$ jeweils Wasserstoffatome oder $C_1$-$C_{12}$-Alkylreste sind und a, b, c, d, e, f, g, h, i, j, k, l, m, n, o und p ganze Zahlen von $0 \leqq a, b, g \leqq 5$, $0 \leqq c, d, e, f, h, i, k, m, o, p \leqq 4$ und $0 \leqq j, l, n \leqq 3$ sind.

2. Vorrichtung nach Anspruch 1, umfassend eine leuchtende Schicht und eine Elektronenlückentransportschicht, wobei die Elektronenlückentransportschicht aus einem Gemisch der aromatischen Aminverbindung und einem Polymer zusammengesetzt ist.

3. Vorrichtung nach Anspruch 2, wobei die Elektronenlückentransportschicht 1 bis 200 Gew.-Teile der aromatischen Aminverbindung pro 100 Gew.-Teile des Polymers umfaßt.

4. Vorrichtung nach Anspruch 1 (a), umfassend eine leuchtende Substanz und eine Elektronenlückentransportsubstanz dispergiert in einem Polymer.

5. Vorrichtung nach Anspruch 4, wobei das Gewichtsverhältnis des Polymers zur Summe der leuchtenden Substanz und der Elektronenlückentransportsubstanz im Bereich von 100 : 0,01 bis 1 : 3 liegt.

6. Vorrichtung nach einem der Ansprüche 2 bis 5, in der das Polymer ausgewählt ist aus Polymeren von N-Vinylcarbazol, Anilin und seinen Derivaten, Thiophen und seinen Derivaten und p-Phenylenvinylen und seinen Derivaten, Polycarbonaten, Polysiloxanen, Vinylpolymeren und Polyethersulfonen.

7. Vorrichtung nach einem der Ansprüche 1 bis 6, in der die Elektronenlückentransportsubstanz ausgewählt ist aus den Verbindungen der Formeln ($B^1$) bis ($B^{15}$):

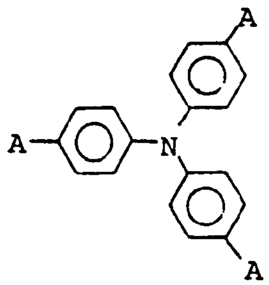
($B_1$)

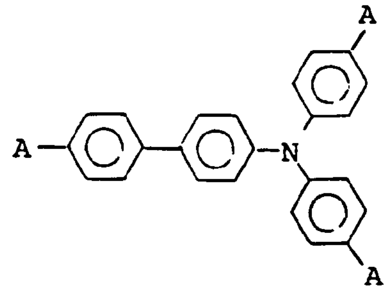
($B_2$)

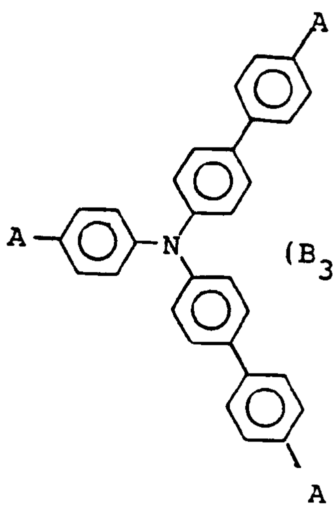
($B_3$)

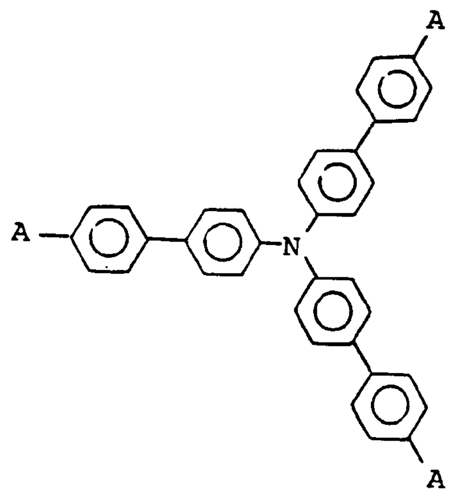
($B_4$)

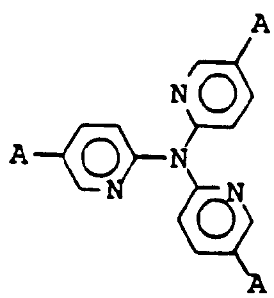
($B_5$)

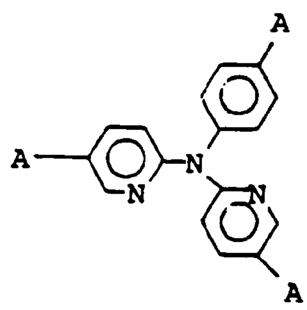
($B_6$)

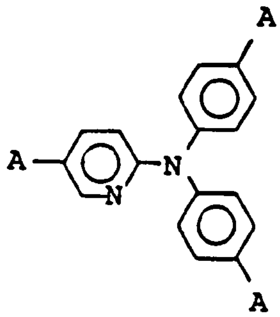

(B7)

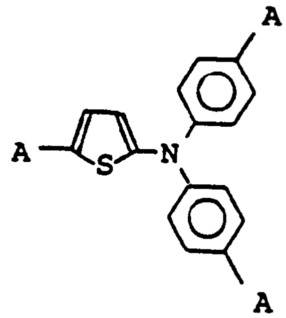

(B8)

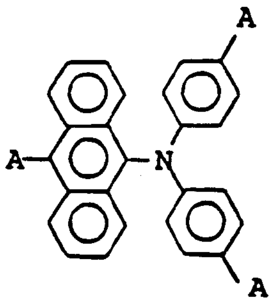

(B9)

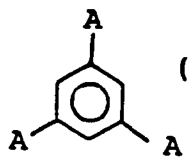

(B10)

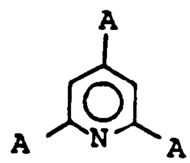

(B11)

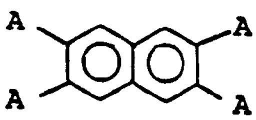

(B12)

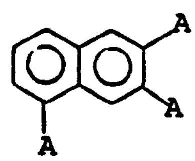

(B13)

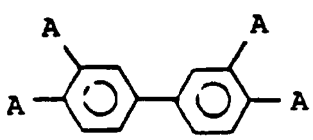

(B14)

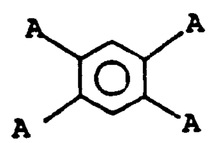

(B15)

wobei in jedem Fall die Reste A gleich oder verschieden sind und jeder Rest A ausgewählt ist aus den Resten der Formeln ($D^1$) bis ($D^6$):

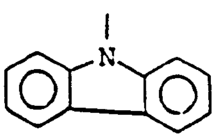

,

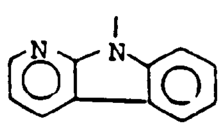

,

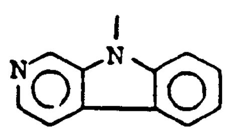

(D1) (D2) (D3)

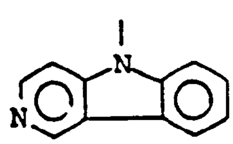

(D4)

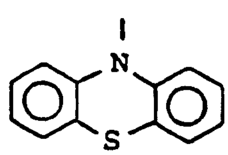

(D5)

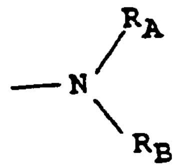

($D_6$)

in denen $R^A$ und $R^B$ gleich oder verschieden sind und jeweils eine Methyl-, Ethyl-, Phenyl-, 2-Methylphenyl-, 3-Methylphenyl-, 4-Methylphenyl-, 2-Ethylphenyl-, 3-Ethylphenyl-, 4-Ethylphenyl-, 4-tert-Butylphenyl-, 4-Methoxyphenyl-, 4-Ethoxyphenyl-, 2-Nitrophenyl-, 4-(Phenyl)phenyl-, 4-(2-Thienyl)phenyl-, 4-(4′-Methylphenyl)phenyl-, 2-Thienyl- oder 2-Pyridylgruppe darstellen, mit der Maßgabe, daß $R_A$ keine Methyl- oder Ethylgruppe ist, wenn $R_B$ eine Methyl- oder Ethylgruppe ist.

**8.** Vorrichtung nach Anspruch 7, wobei die Elektronenlückentransportsubstanz eine Verbindung der Formel ($B^1$) ist, in der A ein Rest ist, ausgewählt aus Resten der Formeln ($D^1$) bis ($D^5$) und Resten der Formel ($D^6$), wobei $R^A$ eine Phenyl-, 2-Methylphenyl-, 3-Methylphenyl-, 4-Methylphenyl-, 2-Ethylphenyl-, 3-Ethylphenyl-, 4-Ethylphenyl-, 4-tert-Butylphenyl-, 4-Methoxyphenyl-, 4-Ethoxyphenyl-, 2-Nitrophenyl-, 4-(Phenyl)phenyl-, 4-(2-Thienyl)phenyl, 4-(4′-Methylphenyl)phenyl-, 2-Thienyl- oder 2-Pyridylgruppe ist und $R_B$ eine 4-tert-Butylphenyl-, 4-Methoxyphenyl-, 4-Ethoxyphenyl-, 2-Nitrophenyl-, 4-(Phenyl)phenyl-, 4-(2-Thienyl)phenyl, 4-(4′-Methylphenyl)phenyl-, 2-Thienyl- oder 2-Pyridylgruppe ist.

**9.** Vorrichtung nach einem der Ansprüche 1 bis 6, wobei die Elektronenlückentransportsubstanz ausgewählt ist aus Verbindungen der Formeln ($B^{16}$) bis ($B^{33}$):

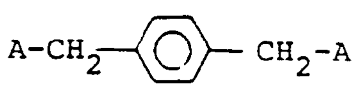

($B_{16}$)

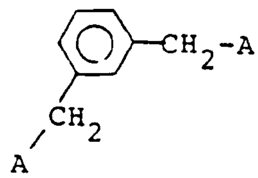

($B_{17}$)

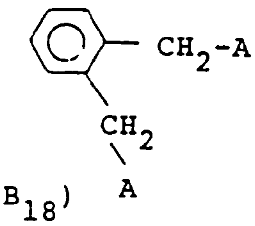

($B_{18}$)

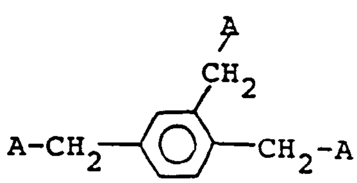

($B_{19}$)

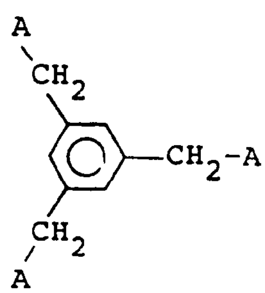

($B_{20}$)

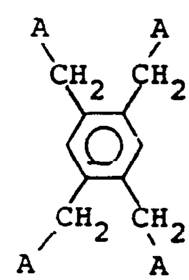

($B_{21}$)

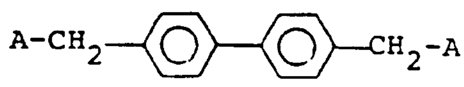

($B_{22}$)

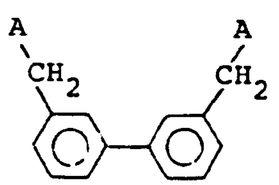

($B_{23}$)

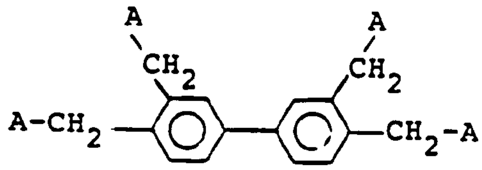

(B24)

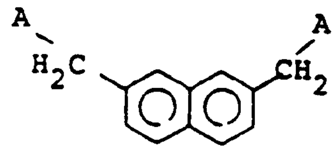

(B25)

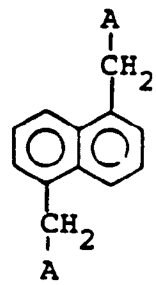

(B26)

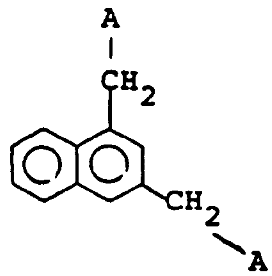

(B27)

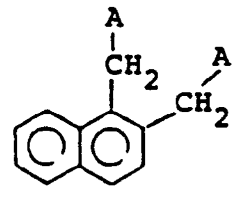

(B28)

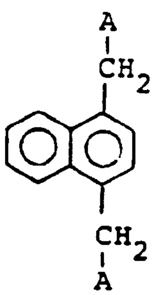

(B29)

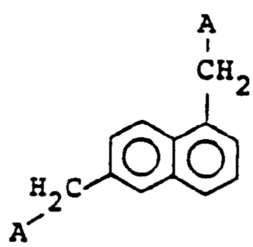

(B30)

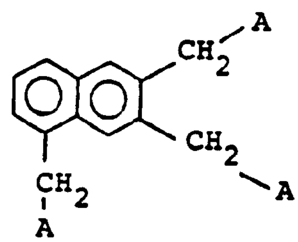

(B31)

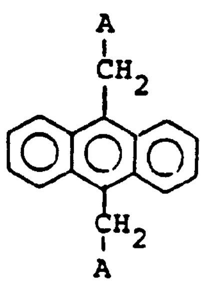

(B32)

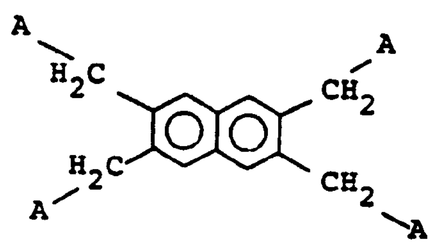

(B33)

wobei in jedem Fall die Reste A gleich oder verschieden sind und jeder Rest A ausgewählt ist aus Resten der Formeln ($D^1$) bis ($D^6$):

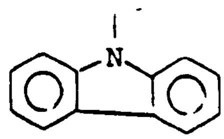 , 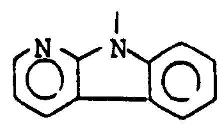 , 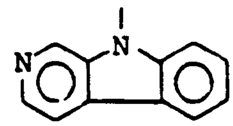

(D1) (D2) (D3)

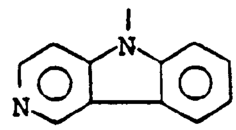 and 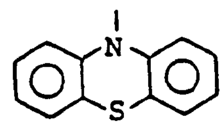

(D4) (D5)

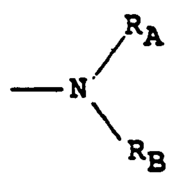

(D6)

in denen $R^A$ oder $R^B$ gleich oder verschieden sind und jeweils eine Methyl-, Ethyl-, Phenyl-, 2-Methylphenyl-, 3-Methylphenyl-, 4-Methylphenyl-, 2-Ethylphenyl-, 3-Ethylphenyl-, 4-Ethylphenyl-, 4-tert-Butylphenyl-, 4-Methoxyphenyl-, 4-Ethoxyphenyl-, 2-Nitrophenyl-, 4-(Phenyl)phenyl-, 4-(2-Thienyl)phenyl-, 4-(4′-Methylphenyl)phenyl-, 2-Thienyl- oder 2-Pyridylgruppe ist, mit der Maßgabe, daß $R^A$ keine Methyl- oder Ethylgruppe ist, wenn $R^B$ eine Methyl- oder Ethylgruppe ist.

## Revendications

**1.** Dispositif électroluminescent organique, comprenant

a) soit une couche luminescente contenant une matière luminescente et une matière de déplacement de trous, le rapport pondéral de la matière luminescente à la matière de déplacement de trous étant compris entre 0,1:100 et 3:1,

b) soit une couche luminescente contenant une matière luminescente, et une couche de déplacement de trous contenant une matière de déplacement de trous,

entre une paire d'électrodes dont l'une au moins est transparente ou translucide, dans lequel la matière de déplacement de trous contient une amine aromatique de formule (1), (2), (3), ou (4):

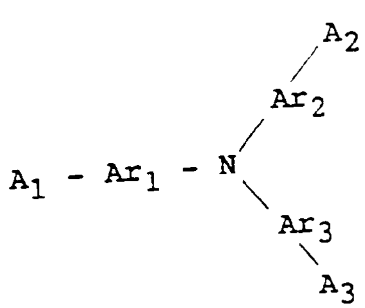 (1) 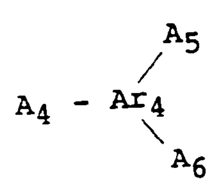 (2)

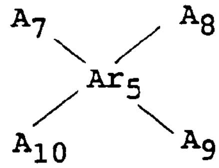

(3)

$Ar_6\text{-}(CH_2 - A_{11})_x$ (4)

dans lesquelles les groupements $Ar^1$, $Ar^2$, $Ar^3$, $Ar^4$, $Ar^5$ et $Ar^6$ sont choisis indépendamment parmi les groupements hydrocarbonés aromatiques renfermant 6 atomes de carbone ou plus et les groupements hétérocycliques aromatiques renfermant 4 atomes de carbone ou plus, x dans la formule (4) est un nombre entier égal à 2 ou plus et les groupements ($CH_2$-$A_{11}$) sont identiques ou différents, et les groupements $A^1$, $A^2$, $A^3$, $A^4$, $A^5$, $A^6$, $A^7$, $A^8$, $8^9$, $A^{10}$ et $A^{11}$ sont choisis indépendamment parmi les groupements de formules (5) à (13):

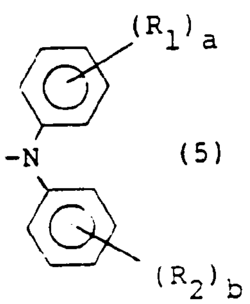

(5) ,

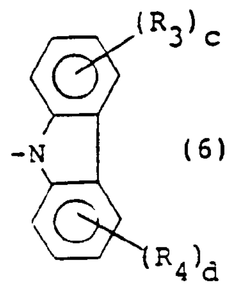

(6) ,

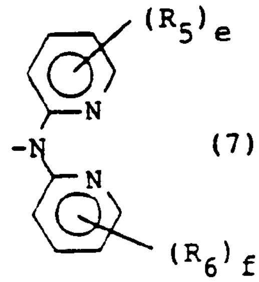

(7) ,

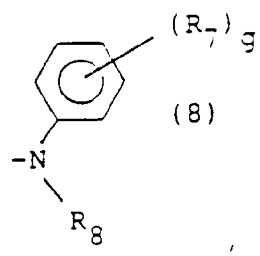

(8) ,

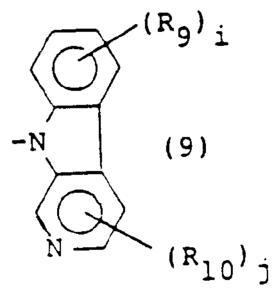

(9) ,

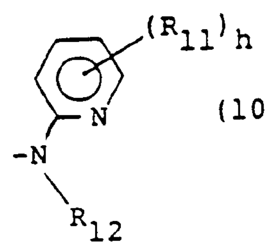

(10) ,

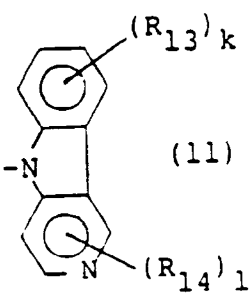

(11) ,

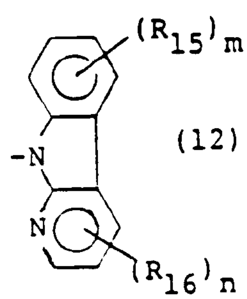

(12)

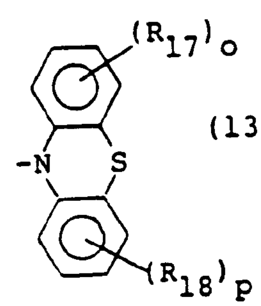

(13)

dans lesquelles chacun des restes $R^1$ à $R^7$, $R^9$ à $R^{11}$ et $R^{13}$ à $R^{18}$ est choisi indépendamment parmi les groupements alkyle et alcoxy en $C_1$-$C_{12}$, aryle et aryloxy en $C_6$-$C_{14}$, nitro et hétérocycliques aromatiques, $R^8$ et $R^{12}$ sont chacun un atome d'hydrogène ou un reste alkyle en $C_1$-$C_{12}$, et a, b, c, d, e, f, g, h, i, j, k, l, m, n, o et p sont des nombres entiers, avec $0 \leqq$ a, b, g $\leqq 5$, $0 \leqq$ c, d, e, f, h, i, k, m, o, p $\leqq 4$ et $0 \leqq$ j, l, n $\leqq 3$.

**2.** Dispositif selon la revendication 1 comprenant une couche luminescente et une couche de déplacement de trous, dans lequel la couche de déplacement de trous est composée d'un mélange du composé amine

aromatique et d'un polymère.

3. Dispositif selon la revendication 2, dans lequel la couche de déplacement de trous comprend 1 à 200 parties en poids du composé amine aromatique pour 100 parties en poids du polymère.

4. Dispositif selon la revendication 1 (a), comprenant une matière luminescente et une matière de déplacement de trous dispersées dans un polymère.

5. Dispositif selon la revendication 4, dans lequel le rapport pondéral du polymère à la somme de la matière luminescente et de la matière de déplacement de trous est compris entre 100:0,01 et 1:3.

6. Dispositif selon l'une quelconque des revendications 2 à 5, dans lequel le polymère est choisi parmi des polymères de N-vinylcarbazole, d'aniline et de ses dérivés, de thiophène et de ses dérivés et de p-phénylènevinylène et de ses dérivés, des polycarbonates, des polysiloxanes, des polymères vinyliques et des polyéthersulfones.

7. Dispositif selon l'une quelconque des revendications 1 à 6, dans lequel la matière de déplacement de trous est choisie parmi les composés de formules ($B^1$) à ($B^{15}$):

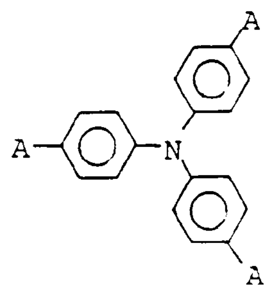
($B_1$)

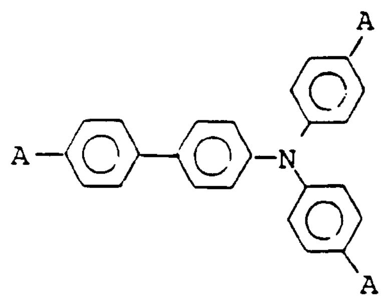
($B_2$)

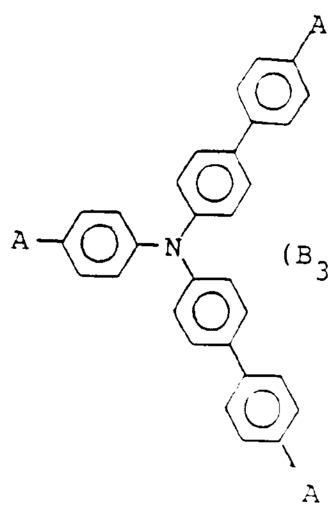
($B_3$)

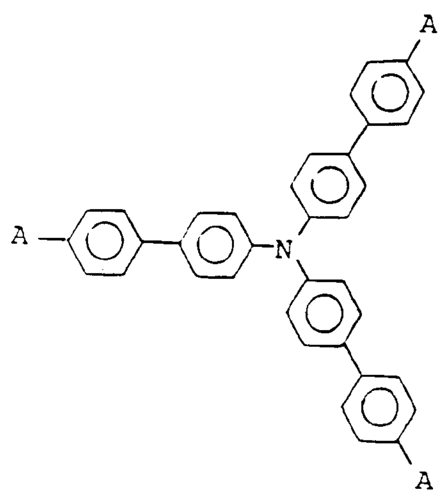
($B_4$)

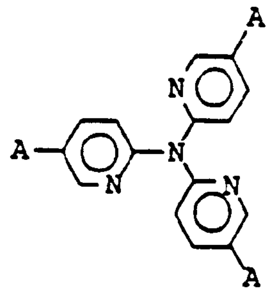
(B5)

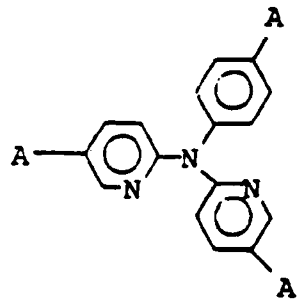
(B6)

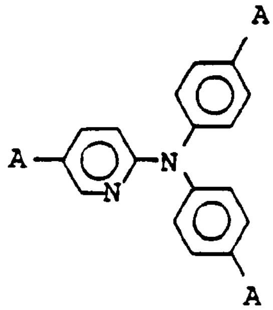
(B7)

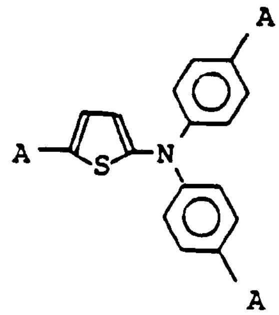
(B8)

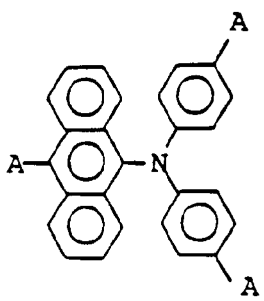
(B9)

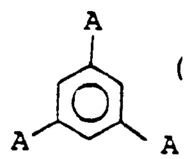
(B10)

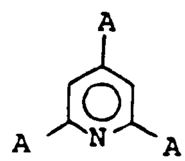
(B11)

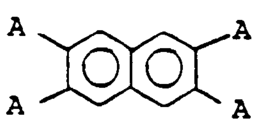
(B12)

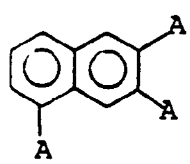
(B13)

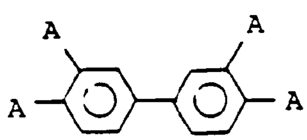
(B14)

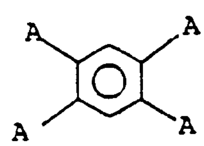
(B15)

dans lesquelles, dans chaque cas, les groupements A sont identiques ou différents et sont choisis chacun parmi les groupements de formules ($D^1$) à ($D^6$):

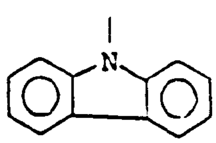
,

(D1)

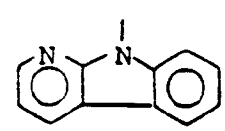
,

(D2)

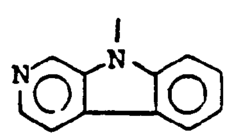

(D3)

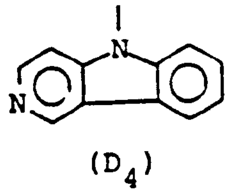

($D_4$)

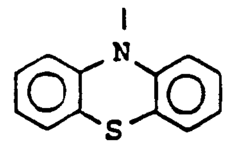

($D_5$)

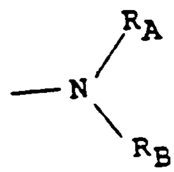

($D_6$)

dans lesquelles $R^A$ et $R^B$ sont identiques ou différents et représentent chacun un reste méthyle, éthyle, phényle, 2-méthylphényle, 3-méthylphényle, 4-méthylphényle, 2-éthylphényle, 3-éthylphényle, 4-éthylphényle, 4-tert.-butylphényle, 4-méthoxyphényle, 4-éthoxyphényle, 2-nitrophényle, 4-(phényl)phényle, 4-(2-thiényl)phényle, 4-(4′-méthylphényl)phényle, 2-thiényle ou 2-pyridyle, étant spécifié que $R^A$ n'est pas un reste méthyle ou éthyle lorsque $R^B$ est un reste méthyle ou éthyle.

**8.** Dispositif selon la revendication 7, dans lequel la matière de déplacement de trous est un composé de formule ($B^1$) dans laquelle A est un groupement choisi parmi les groupements de formules ($D^1$) à ($D^5$) et les groupements de formule ($D^6$) dans lesquels $R^A$ est un reste phényle, 2-méthylphényle, 3-méthylphényle, 4-méthylphényle, 2-éthylphényle, 3-éthylphényle, 4-éthylphényle, 4-tert.-butylphényle, 4-méthoxyphényle, 4-éthoxyphényle, 2-nitrophényle, 4-(phényl)phényle, 4-(2-thiényl)phényle, 4-(4′-méthylphényl)phényle, 2-thiényle ou 2-pyridyle, et $R^B$ est un reste 4-tert.-butylphényle, 4-méthoxyphényle, 4-éthoxyphényle, 2-nitrophényle, 4-(phényl)phényle, 4-(2-thiényl)phényle, 4-(4′-méthylphényl)phényle, 2-thiényle ou 2-pyridyle.

**9.** Dispositif selon l'une quelconque des revendications 1 à 6, dans lequel la matière de déplacement de trous est choisie parmi les composés de formules ($B^{16}$) à ($B^{33}$):

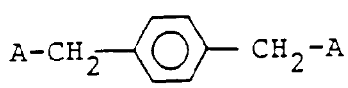

($B_{16}$)

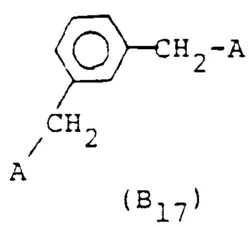

($B_{17}$)

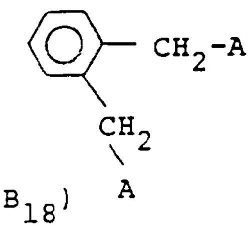

($B_{18}$)

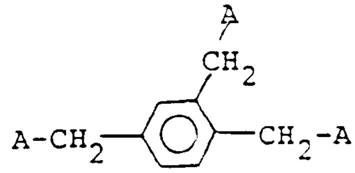

($B_{19}$)

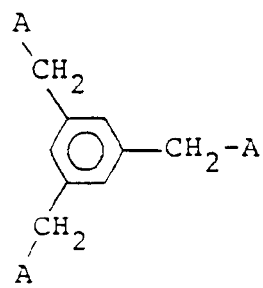

($B_{20}$)

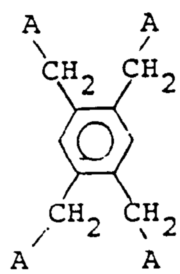

($B_{21}$)

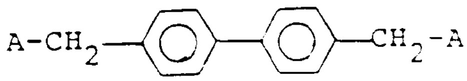

$(B_{22})$

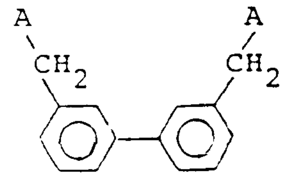

$(B_{23})$

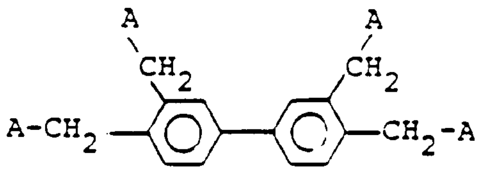

$(B_{24})$

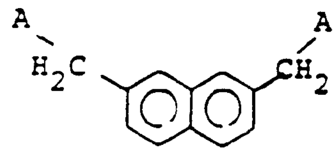

$(B_{25})$

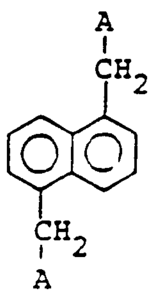

$(B_{26})$

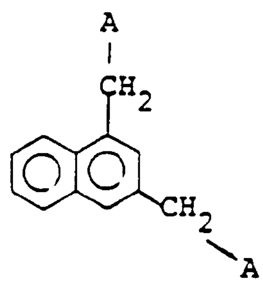

$(B_{27})$

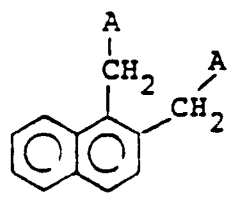

$(B_{28})$

$(B_{29})$

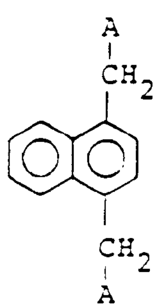

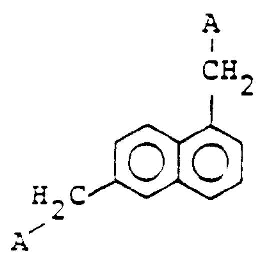

$(B_{30})$

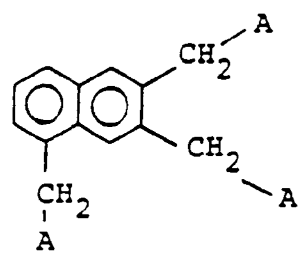

$(B_{31})$

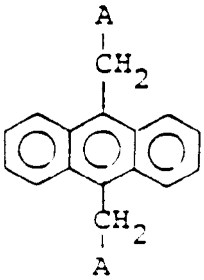

($B_{32}$)

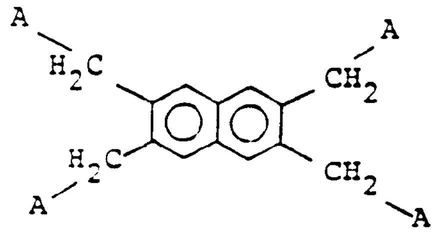

($B_{33}$)

dans lesquelles, dans chaque cas, les groupements A sont identiques ou différents et chaque groupement A est choisi parmi les groupements de formules ($D^1$) à ($D^6$)

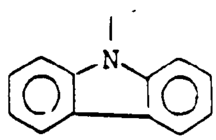

,

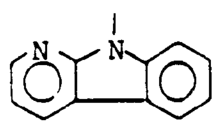

,

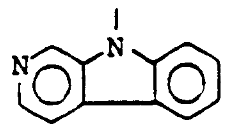

($D_1$) ($D_2$) ($D_3$)

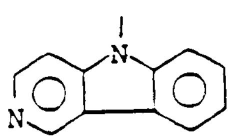

et

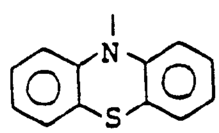

($D_4$) ($D_5$)

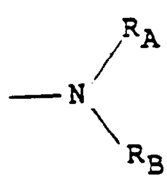

($D_6$)

dans lesquelles $R^A$ et $R^B$ sont identiques ou différents et représentent chacun un reste méthyle, éthyle, phényle, 2-méthylphényle, 3-méthylphényle, 4-méthylphényle, 2-éthylphényle, 3-éthylphényle, 4-éthylphényle, 4-tert.-butylphényle, 4-méthoxyphényle, 4-éthoxyphényle, 2-nitrophényle, 4-(phényl)phényle, 4-(2-thiényl)phényle, 4-(4'-méthylphényl)phényle, 2-thiényle ou 2-pyridyle, étant spécifié que $R^A$ n'est pas un reste méthyle ou éthyle losrque $R^B$ est un reste méthyle ou éthyle.